# EUROPEAN PATENT APPLICATION

(11) **EP 4 766 143 A1**
(43) Date of publication of application: **24.06.2026**
(21) Application number: 25214875.4
(22) Date of filing: 11.11.2025
(51) Int. Cl.: H10W 70/685, H10W 72/20, H10W 90/00

(54) **MICROELECTRONIC ASSEMBLIES WITH DISAGGREGATED COMPONENTS**

(30) Priority: 23.12.2024 US 202419000282
(71) Applicant: Intel Corporation, Santa Clara, CA 95054 (US)
(72) Inventor: KAMGAING, Telesphor, Chandler, AZ 85249 (US)
(74) Representative: HGF

(57) **Abstract**

In one example, a microelectronic assembly with disaggregated components includes an interposer over a substrate and conductive interconnects (e.g., one or more of conductive pillars, solder caps, and solder balls) between and coupled with the substrate and the interposer. One or more dies may be coupled with a top side of the interposer. A further die may be coupled with the package side of the interposer. The further die may be, for example, in the bump field between the interposer and the substrate. In some examples, the further die may be embedded in the substrate. In some examples, the further die may be TSV-less, and lack conductive interconnects in direct contact with conductive contacts of the substrate. In some examples, the further die may be embedded within redistribution layers (RDLs) of the interposer and coplanar with conductive pillars between RDLs.

## Description

### Background

Electronic circuits when commonly fabricated on a wafer of semiconductor material, such as silicon, are called integrated circuits (ICs). The wafer with such ICs is typically cut into numerous individual dies. The dies may be packaged into an IC package containing one or more dies along with other electronic components such as resistors, capacitors, and inductors. The IC package may be integrated onto an electronic system, such as a consumer electronic system, or servers, such as mainframes.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIGS. 1A-1B, 2-7, 8A-8B, and 9-13 illustrate different cross-sectional views of examples of microelectronic assemblies with disaggregated components, according to some embodiments of the present disclosure.
FIGS. 14A-14B illustrate cross-sectional side views of examples of dies which may be included in microelectronic assemblies with disaggregated components, according to some embodiments of the present disclosure.
FIGS. 15A-15C illustrate cross-sectional side views of examples of substrates which may be included in microelectronic assemblies with disaggregated components, according to some embodiments of the present disclosure.
FIG. 16 illustrates a plan view of an example of a system that may be implemented as a microelectronic assembly with disaggregated components, in accordance with embodiments of the present disclosure.
FIG. 17 is a top view of a wafer and dies that may be included in any microelectronic assembly disclosed herein, in accordance with any of the embodiments disclosed herein.
FIG. 18 is a side, cross-sectional view of an IC package that may include, or be included in, any microelectronic assembly disclosed herein, in accordance with various embodiments.
FIG. 19 is a side, cross-sectional view of an IC device assembly that may include or be an example of a microelectronic assembly disclosed herein, in accordance with any of the embodiments disclosed herein.
FIG. 20 is a block diagram of an example electrical device that may include, or be included in, any of the microelectronic assemblies disclosed herein, in accordance with any of the embodiments disclosed herein.

### Detailed Description

Disclosed herein are microelectronic assemblies with disaggregated components. The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

Semiconductor chip manufacturing involves a series of complex processes to create integrated circuit (IC) structures. These processes include photolithography, ion implantation, etching, and deposition. A wafer typically goes through multiple rounds of these processes to form devices and interconnects on the wafer. Once the wafer processing is complete, the wafer may be cut into individual chips (also called dies). After dicing, the individual dies are packaged to provide interconnections with other components and protection.

Packaging the dies may involve attaching the dies to a substrate (such as a motherboard, interposer, or other circuit board or structure with conductive interconnects) to connect the die's conductive contacts to the package's conductive contacts (e.g., with flip chip bonding, ball grid array (BGA), etc.). For attachment to a circuit board, a die may be soldered directly onto the board or inserted into a socket (e.g., in the case of a packaged die). In some cases, multiple dies may be combined (e.g., stacked) into a single assembly or package before being mounted on the circuit board.

In some examples, components may be embedded into an interposer. For example, a bridge die may be embedded into an interposer, and other IC dies attached to the interposer may be interconnected with one another through the such an embedded bridge die. In some examples, active dies may be embedded in an interposer. However, embedding active dies in the mold of an interposer may lead to poor heat dissipation and other thermal challenges. Additionally, embedded dies can significantly increase the cost and complexity of assembly. For example, an embedded bridge die may need to be thinned to reveal through-silicon vias or through substrate vias (TSVs) at the faces of the bridge die, attached to the interposer, and secured with an underfill and/or molding material around the bridge die, which may increase the cost and complexity of assembly. Furthermore, using an embedded bridge die with TSVs that extend through the bridge die typically involves forming conductive pads on the backside of the bridge die, which may increase the height of the embedded bridge die, as well as increase the complexity of the bridge die or assembly.

In contrast, microelectronic assemblies with disaggregated and "TSV-less" components in accordance with examples described herein can enable lower-cost disaggregated architectures. In one example, a die (e.g., bridge die or other passive or active die) may be attached to a backside of an interposer (e.g., between the interposer and a substrate with which the interposer is coupled). The die may be TSV-less in the sense that the die may lack vias that extend through the die (e.g., from one face of the die to the opposing face of the die, and/or through the bulk of the semiconductor substrate of the die). However, as used herein, a TSV-less die may include vias interconnecting layers within the die, and/or interconnecting a layer of the die with a contact on one face of the die). Thus, in one example, conductive contacts on the die (e.g., on one of the faces of the die) are limited to a side of the die facing the interposer.

In one example, the die may be in the bump field, e.g., in the same layer or plane with conductive bumps or other interconnects that couple the interposer with a package substrate. In one example, the die may be embedded in the substrate. In one example, the assembly may include multiple dies coupled with the backside of the interposer, with conductive bumps or other interconnects coplanar and between the dies. In one such example, a bridge die or other die may be "split" across two or more dies, which may enable room for conductive bumps or other interconnects to pass between adjacent split dies. In some examples, the die may have at least one side exposed to air (e.g., there may be an airgap or void between the die and the substrate, between the die and the interposer, and/or at the sides of the die). Exposure of the backside of dies in the bump field may enable flexible thermal solutions for such dies. In some examples, an underfill material may be present between the die and the interposer, and/or between the die and the substrate.

In another example, disaggregated TSV-less components may be embedded in the interposer. In one such example, a microelectronic assembly may include dies between redistribution layers (RDLs) of an interposer, and conductive vias may be present between and coplanar with the dies. Using the space between and/or around dies that are embedded or attached to the backside of an interposer for conductive bumps and/or vias can enable reducing the complexity and cost of assembly.

IC assemblies with disaggregated components as described herein may be implemented in one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on an IC or those connected to an IC. The IC may be either analog or digital and may be used in a number of applications, such as microprocessors, optoelectronics, logic blocks, audio amplifiers, etc., depending on the components associated with the IC. In some embodiments, IC structures as described herein may be included in a radio frequency IC (RFIC), which may, e.g., be included in any component associated with an IC of an RF receiver, an RF transmitter, or an RF transceiver, e.g., as used in telecommunications within base stations (BS) or user equipment (UE). Such components may include, but are not limited to, power amplifiers, low-noise amplifiers, RF filters (including arrays of RF filters, or RF filter banks), switches, upconverters, downconverters, and duplexers. In some embodiments, IC structures as described herein may be included in memory devices or circuits. In some embodiments, IC structures as described herein may be employed as part of a chipset for executing one or more related functions in a computer.

For purposes of explanation, specific numbers, materials, and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations. The terms "substantially," "close," "approximately," "near," and "about," generally refer to being within +/- 10% of a target value, e.g., within +/- 5% of a target value, based on the context of a particular value as described herein or as known in the art. Similarly, terms indicating orientation of various elements, e.g., "coplanar," "perpendicular," "orthogonal," "parallel," or any other angle between the elements, generally refer to being within +/- 10% of a target value, e.g., within +/- 5% of a target value, based on the context of a particular value as described herein or as known in the art.

In the following description, references are made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

In the drawings, while some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the fabricating processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of a microelectronic assembly with disaggregated components as described herein.

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner. Although some materials may be described in singular form, such materials may include a plurality of materials, e.g., a semiconductor material may include two or more different semiconductor materials.

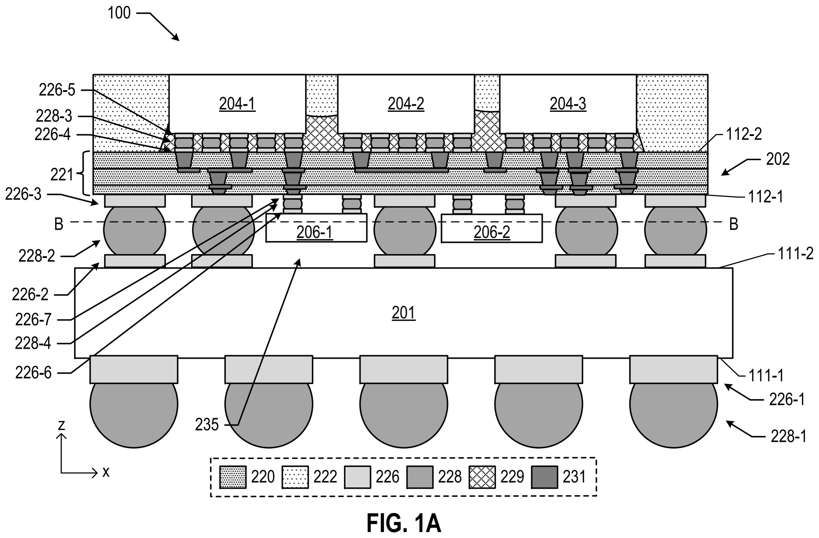

A number of elements referred to in the description of FIGS. 1A-1B, 2-7, 8A-8B, 9-13, 14A-14B, and 15A-15C with reference numerals are illustrated in these drawings with different patterns, with a legend showing the correspondence between the reference numerals and patterns being provided at the bottom of each drawing page containing FIGS. FIGS. 1A-1B, 2-7, 8A-8B, 9-13, 14A-14B, and 15A-15C. For example, the legend illustrates that FIGS. 1A-1B use different patterns to show a conductive pad 226 and a conductive bump 228, and so on.

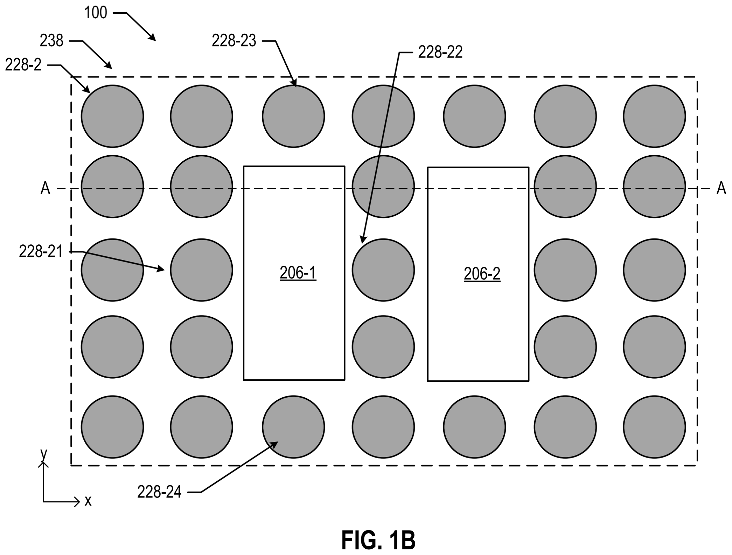

FIGS. 1A-1B illustrate different cross-sectional views of an example of a microelectronic assembly 100 with disaggregated components, according to some embodiments of the present disclosure. FIG. 1A illustrates a cross-section in the x-z plane of the example coordinate system shown in FIGS. 1A-1B along a plane AA shown in FIG. 1B. FIG. 1B illustrates a cross-section in the x-y plane of the example coordinate system shown in FIGS. 1A-1B along a plane BB shown in FIG. 1A.

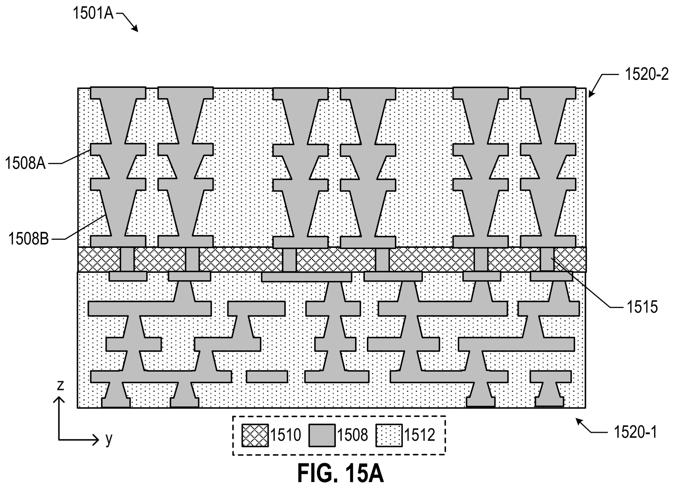

FIG. 1A illustrates a cross-sectional side view of a microelectronic assembly 100. The microelectronic assembly 100 includes a substrate 201 with a first side or face 111-1 (e.g., top or front side) and a second side or face 111-2 (e.g., bottom or back side) opposite the first face 111-1. The substrate 201 may be, e.g., a package substrate. The substrate 201 may include an insulating material (e.g., a dielectric material formed in multiple layers, as known in the art) and one or more conductive pathways to route power, ground, and signals through the dielectric material (e.g., including conductive traces and/or conductive vias). In some examples, the substrate 201 may include a substrate core with layers above and below the core. In other examples, the substrate 201 may be coreless (e.g., lacking a core of a different material). Examples of substrates are shown in FIGS. 15A-15C, discussed below. In some embodiments, the insulating material of the substrate 201 may be a dielectric material, such as an organic dielectric material, a fire retardant grade 4 material (FR-4), bismaleimide triazine (BT) resin, polyimide materials, glass reinforced epoxy matrix materials, organic dielectrics with inorganic fillers or low-k and ultra low-k dielectric (e.g., carbon-doped dielectrics, fluorine-doped dielectrics, porous dielectrics, and organic polymeric dielectrics). In particular, when the substrate 201 is formed using standard printed circuit board (PCB) processes, the substrate 201 may include FR-4, and the conductive pathways in the substrate 201 may be formed by patterned sheets of copper separated by buildup layers of the FR-4. In some embodiments, the substrate 201 may be formed using a lithographically defined via packaging process. In some embodiments, the substrate 201 may be manufactured using standard organic package manufacturing processes, and thus the substrate 201 may take the form of an organic substrate. In some embodiments, the substrate 201 may be a set of redistribution layers formed on a panel carrier by laminating or spinning on a dielectric material, and creating conductive vias and lines by laser drilling and plating. In some embodiments, the substrate 201 may be formed on a removable carrier using any suitable technique, such as a redistribution layer technique. Any method known in the art for fabrication of the substrate 201 may be used, and for the sake of brevity, such methods will not be discussed in further detail herein.

Conductive contacts 226-1 on the face 111-1 of the substrate 201 may couple with conductive bumps 228-1, which may couple with a circuit board, such as a mother board or other circuit board or interconnect structure. As used herein, a "conductive contact" may refer to a portion of conductive material (e.g., metal) serving as an electrical interface between different components (e.g., part of a conductive interconnect); conductive contacts may be recessed in, flush with, or extending away (e.g., having a pillar shape) from a surface of a component, and may take any suitable form (e.g., a conductive pad or socket, or portion of a conductive line or via). In a general sense, an "interconnect" refers to any element that provides a physical connection between two other elements. For example, an electrical interconnect provides electrical connectivity between two electrical components, facilitating communication of electrical signals between them. Thus, when used with reference to an electronic device, such as an IC that operates using electrical signals, the term "interconnect" describes any element formed of a conductive material for providing electrical connectivity to one or more elements associated with the IC or/and between various such elements. In such cases, the term "interconnect" may refer to both conductive traces (also sometimes referred to as "metal traces," "lines," "metal lines," "wires," "metal wires," "trenches," or "metal trenches") and conductive vias (also sometimes referred to as "vias" or "metal vias"). Sometimes, conductive traces and vias may be referred to as "metal traces" and "metal vias", respectively, to highlight the fact that these elements include conductive materials such as metals.

An interface with conductive bumps 228 may include a plurality of coplanar bumps between the two bonded IC structures (e.g., between two dies, between a die and an interposer, between an interposer and a package substrate, etc.). The conductive bumps 228 are typically coupled with conductive elements, such as conductive pads 226. In some examples, conductive bumps 228 that are relatively tall (e.g., conductive bumps which have a greater height than width) and/or which have a cross-sectional shape that is substantially cylindrical with relatively straight sides (as opposed to rounded convex sides) may be referred to as conductive pillars. In some examples, the bumps may be arranged in an array, such as in ball grid array (BGA) assemblies. Conductive bumps may be formed to have various shapes (e.g., spherical/round, cylindrical, etc.), which may be deformed after bonding. Conductive bumps include a conductive material (e.g., one or more metals), such as solder, copper, gold, or other suitable conductive material. Conductive bumps that include solder may include any appropriate solder material, such as lead/tin, tin/bismuth, eutectic tin/silver, ternary tin/silver/copper, eutectic tin/copper, tin/nickel/copper, tin/bismuth/copper, tin/indium/copper, tin/zinc/indium/bismuth, or other alloys. In some examples, conductive bumps, such as pillars, may include a metal such as copper, and be capped with a solder cap. Thus, in some examples, an interconnect may include a first conductive portion (such as a metal bump or pillar) and a second conductive portion (such as a solder cap). In some examples, the conductive bumps 228 are surrounded by an insulator material (sometimes referred to as a filler or underfill material) in a plane with the conductive bumps; however, an underfill material is not shown around the conductive bumps 228-1 in FIG. 1A. An underfill material may be provided according to any suitable method (e.g., deposited before or after formation of the bumps), and may provide mechanical support to an interface layer with conductive bumps 228. Underfill material may be any suitable insulator material, such as silicon oxide, silicon carbide, silicon oxynitride, carbon-doped silicon oxide, spin-on-glass, boron-doped silicon oxide, an organic polymer, carbon, a carbon polymer, or any other suitable insulator material.

The assembly 100 also includes an interposer 202 with a first face 112-1 (e.g., a bottom or back side) and a second face 112-2 (e.g., a top or front side) opposite the first face 112-1. The face 112-1 of the interposer 202 may also be referred to as a package side. In the example illustrated in FIG. 1A, the interposer 202 is coupled with the substrate 201 via a plurality of conductive bumps 228-2, which are in between conductive contacts 226-2 on the face 111-2 of the substrate 201 and conductive contacts 226-3 on the face 112-1 of the interposer 202. An interposer is typically an intermediate structure in a microelectronic assembly that enables electrically coupling IC structures with one another. For example, the interposer 202 facilitates coupling the IC dies 204-1, 204-2, and 204-3 with one another and/or with the substrate 201, as can be seen in the cross-sectional side view of FIG. 1A. The interposer 202 may include one or more layers of a dielectric material 220 and conductive interconnects 231 (e.g., conductive lines and vias) in the dielectric material. Such layers (e.g., layers of a dielectric material 220 with conductive interconnects 231) may be referred to as RDLs 221. Although the interposer 202 of FIG. 1A is shown as having three RDLs 221, interposers may have fewer (e.g., one or two RDLs) or more (e.g., four, five, six, or more than six) RDLs. The dielectric material 220 of the interposer 202 may include silicon (e.g., in the case of a silicon-based interposer), an organic dielectric material (e.g., in the case of an organic interposer), or both a dielectric material that includes silicon and an organic dielectric material. Examples of silicon-based dielectric materials that may be included in one or more layers of the interposer 202 include silicon and one or more of oxygen and nitrogen (e.g., silicon oxide, silicon nitride, or silicon oxynitride). Examples of organic dielectric materials that may be included in one or more layers of the interposer 202 include a fire retardant grade 4 material (FR-4), BT resin, polyimide materials, glass reinforced epoxy matrix materials, organic dielectrics with inorganic fillers or low-k and ultra low-k dielectric (e.g., carbon-doped dielectrics, fluorine-doped dielectrics, porous dielectrics, and organic polymeric dielectrics).

In the example illustrated in FIG. 1A, the dies 204-1, 204-2, and 204-3 are coupled with the face 112-2 of the interposer 202 with conductive bumps 228-3, which are between conductive contacts 226-4 on the face 112-2 of the interposer 202 and conductive contacts 226-5 on the bottom sides of the dies 204-1, 204-2, and 204-3. The dies 204-1, 204-2, and 204-3 may be, for example, discrete IC structures, which may be referred to as chiplets, which may be packaged together. Often, different chiplets in an IC device or system may include logic to provide a particular functionality in the IC device or system, such as computation, memory, and I/O. For example, an IC device may include one or more compute chiplets, memory chiplets, cache chiplets, accelerator chiplets, etc. The terms IC die, die, chiplet, chip, and microelectronic component may be used interchangeably. For example, a compute chiplet may also be referred to as a compute die. In one example, a compute chiplet may include one or more processor cores and/or other compute logic. In one example, a compute chiplet that includes one or more processor cores may be referred to as a processor chiplet or processor die. A memory chiplet may include one or more memory arrays (e.g., dynamic random access memory (DRAM) and/or static random access memory (SRAM) arrays). A cache chiplet may include one or more memory arrays (e.g., an SRAM array or other low latency memory). Chiplets may have more than one type of device, for example, a compute chiplet may also include one or more memory arrays, and a memory chiplet may include compute logic. The dies 204-1, 204-2, and 204-3 may be dies that include electrical load circuits that consume power. An underfill material 229 may be at least partially surround the conductive bumps 228-3. A molding material 222 may at least partially surround the dies 204-1, 204-2, and 204-3, and may be over the underfill material 229, as shown in FIG. 1A. The molding material 222 may be any material known to be suitable for over-molded IC packages, such as an epoxy resin, silicone, a composite thereof, or any other suitable molding compound. In other examples, the molding material 222 may be absent from over or around the dies 204-1, 204-2, and 204-3.

The microelectronic assembly 100 also includes dies on the back side (e.g., the face 112-1) of the interposer 202. For example, the dies 206-1 and 206-2 are coupled with the face 112-1 of the interposer 202 with conductive bumps 228-4, which are between conductive contacts 226-6 on the dies 206-1, 206-2 and conductive contacts 226-7 on the face 112-1 of the interposer 202. The dies 206-1 and 206-2 may be active or passive dies. For example, the one or both of the dies 206-1 and 206-2 may be passive interconnect or bridge dies, which include interconnects between the dies 204-1, 204-2, and/or 204-3 coupled with the frontside of the interposer 202. In some examples, active interconnect or bridge dies may include one or more transistors (e.g., transistors configured as switches) to enable the configuration of signal routing on the die. In some examples, one or both of the dies 206-1 and 206-2 include one or more capacitors (e.g., capacitors for voltage regulation circuits, high frequency noise suppression, and/or power supply voltage stabilization). In some examples, one or both of the dies 206-1 and 206-2 include memory (e.g., SRAM or DRAM). In some examples, the dies 206-1 and 206-2 may be two "split" dies (e.g., split bridge dies or split dies with capacitors) in which the functionality of a bridge die or die with a capacitor is split across the two dies 206-1 and 206-2. In one such example, the split dies enable the placement of an interconnect between the split dies to couple one of the dies 204-1, 204-2, and 204-3 with the substrate 201 without relying on a TSV through the dies 206-1 and 206-2. Thus, in some examples, the dies 206-1 and 206-2 lack TSVs that extend through the entire die, and conductive contacts on the dies 206-1 and 206-2 are limited to the side of the die facing the bottom of the interposer 202 (e.g., the face 112-1 of the interposer 202). Although two dies 206-1 and 206-2 are shown as being attached to the backside of the interposer 202, other assemblies may include a single die coupled with the backside of the interposer 202 in the bump field, or more than two dies coupled with the backside of the interposer 202 in the bump field.

Conductive bumps and contacts between different components of the microelectronic assembly 100 may have different pitches and/or widths. The width of a conductive bump or contact is a dimension of the conductive bump or contact in a plane substantially parallel with the substrate 201 or interposer 202. The pitch of conductive contacts is a measure of distance between an approximate center of a contact and an approximate center of an adjacent contact. Similarly, the pitch of conductive bumps is a measure of distance between an approximate center of a bump and an approximate center of an adjacent bump. In the example illustrated in FIG. 1A, the conductive bumps 228-1 and corresponding conductive contacts 226-1 at the bottom of the substrate 201 have the greatest width and pitch (relative to the conductive bumps and contacts between the substrate 201 and interposer 202, and between the interposer 202 and dies 206-1, 206-2, 204-1, 204-2, and 204-3). In one example the width of the conductive bumps 228-1 may be in a range of about 200 to 600 microns. In other examples, conductive bumps may be absent from the bottom of the substrate 201 (e.g., in the case where the assembly 100 is inserted into a socket rather than bonded to an underlying substrate or circuit board with solder balls).

The width and pitch of the conductive bumps 228-2 and contacts 226-2 and 226-3 between the substrate 201 and the interposer 202 may be smaller than the width and pitch of the conductive bumps 228-1 and contacts 226-1 at the bottom of the substrate 201. However, in some examples, the conductive contacts 226-3 on the interposer 202 and coupled with the substrate have a greater width and pitch than the conductive contacts 226-7 and 226-4 coupled with the dies 206-1 and 206-2, and the dies 204-1, 204-2, and 204-3. In one example, the conductive bumps 228-2 have a width in a range of about 40 to 120 microns, about 50-75 microns, or about 50-60 microns. In one example, the width of the conductive bumps 228-4 between the backside of the interposer 202 and the dies 206-1 and 206-2 may be in a range of about 20 to 50 microns. In one such example, the pitch of the conductive bumps may be in a range of about 40 to 110 microns. Thus, in some examples, the bottom side of the interposer 202 may have relatively wider conductive contacts 226-3 for coupling with the larger conductive bumps 228-2 and relatively narrower conductive contacts 226-7 for coupling with the smaller conductive bumps 228-4 between the dies 206-1 and 206-2 and the interposer 202. In one such example, the pitch of the conductive bumps 228-2 is greater than the pitch of the conductive bumps 228-4 and the conductive bumps 228-3.

As can be seen in FIG. 1A, the dies 206-1 and 206-2 are in the "bump field" that includes the conductive bumps 228-2 between the interposer 202 and the substrate 201. As used herein, the term bump field may refer to a region in the same layer as conductive bumps and/or pillars (such as an array of conductive bumps). For example, the dies 206-1 and 206-2 are coupled with the interposer 202 with conductive contacts 226-7 and 226-6 and conductive bumps 228-4, and disposed in the same layer and/or plane as the conductive bumps 228-2. Thus, the conductive dies 206-1 and 206-2 may be considered to be in the bump field of the conductive bumps 228-2. In some examples, one or both of the dies 206-1 and 206-2 may be between conductive bumps (e.g., between two adjacent bumps 228-2), or bordered by conductive bumps on two or more sides. For example, FIG. 1B illustrates a cross-section in the x-y plane along a plane BB shown in FIG. 1A.

FIG. 1B depicts a bump array 238, where the dies 206-1 and 206-2 are in the same layer as the bump array 238. In the example illustrated in FIG. 1B, the dies 206-1 and 206-2 are surrounded by conductive bumps in the plane BB. For example, the die 206-1 has four sides, a first conductive bump 228-21 is adjacent to a first side, a second conductive bump 228-22 is adjacent to a second side, a third conductive bump 228-23 is adjacent to a third side and a fourth conductive bump 228-24 is adjacent to a fourth side. Thus, the die 206-1 is between the conductive bumps 228-1 and 228-2 along one axis (e.g., the y-axis as shown in FIG. 1B) and between the conductive bumps 228-23 and 228-24 along another axis (e.g., the x-axis as shown in FIG. 1B). In some examples, there may be multiple dies in the conductive bump field, such as shown in FIG. 1B. In the example illustrated in FIG. 1B, the microelectronic assembly 100 includes two dies 206-1 and 206-2 (e.g., two coplanar dies) in the same layer with the conductive bump array 238. In one such example, one or more of the conductive bumps 228-2 are between the die 206-1 and the second die 206-2.

Referring again to FIG. 1A, the dies 206-1 and 206-2 of the microelectronic assembly 100 are exposed (e.g., exposed to air) on all sides of the dies 206-1 and 206-2. For example, an underfill material is absent from between the face 112-1 of the interposer 202 and the die 206-1 in a plane with the conductive bumps 228-4, between the die 206-1 and the substrate 201, and between the sides of the dies 206-1 and the adjacent conductive bumps 228-2. In one such example, as a result of the lack of an underfill material, the assembly 100 includes airgaps between the die 206-1 and the face 112-1 of the interposer 202, between the die 206-1 and the substrate 201 (e.g., as shown by the airgap 235), and between the die 206-1 and adjacent conductive bumps 228-2. In one example, an airgap may be a region that is substantially devoid of solid material. The airgap may include minimal or no material, or the airgap may be filled with a gaseous substance, e.g., air, nitrogen gas, and/or a different gas. An airgap may also be referred to as a void. In other examples, an insulator material (e.g., an underfill material and/or a molding compound) may be present on one or more sides of the dies 206-1 and 206-2.

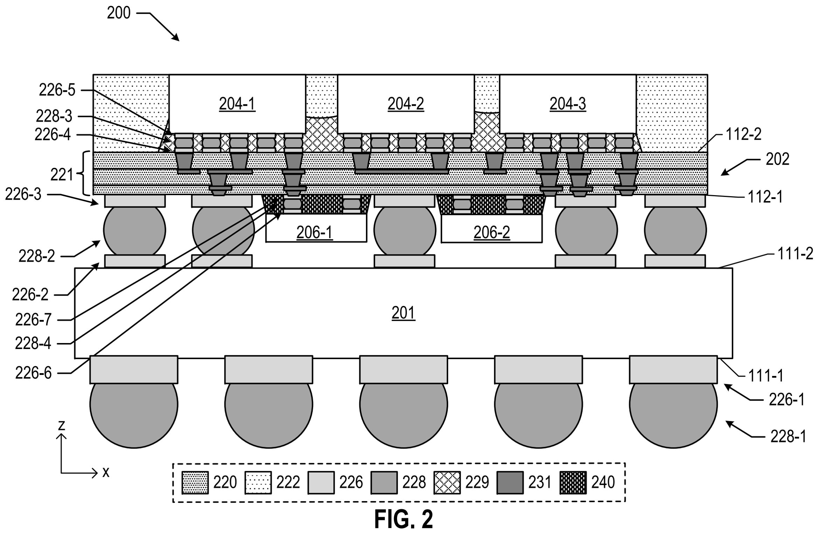

For example, FIG. 2 illustrates an example microelectronic assembly 200 that includes an underfill material 240 between the bottom side (e.g., the face 112-1) of the interposer 202 and the dies 206-1 and 206-2. In one such example, the underfill material 240 may be limited to the regions between the face 112-1 of the interposer 202 and the dies 206-1 and 206-2 in a plane with the conductive bumps 228-4, and may be absent from around and between adjacent conductive contacts 226-2 and 226-3 and absent from around and between adjacent conductive bumps 228-2. In one such example, the underfill material 240 may provide structural support for solder joints formed from the conductive bumps 228-4 (e.g., during downstream processes that may involve heating the assembly 200). The underfill material 240 may be the same as, or different from, the underfill material 229.

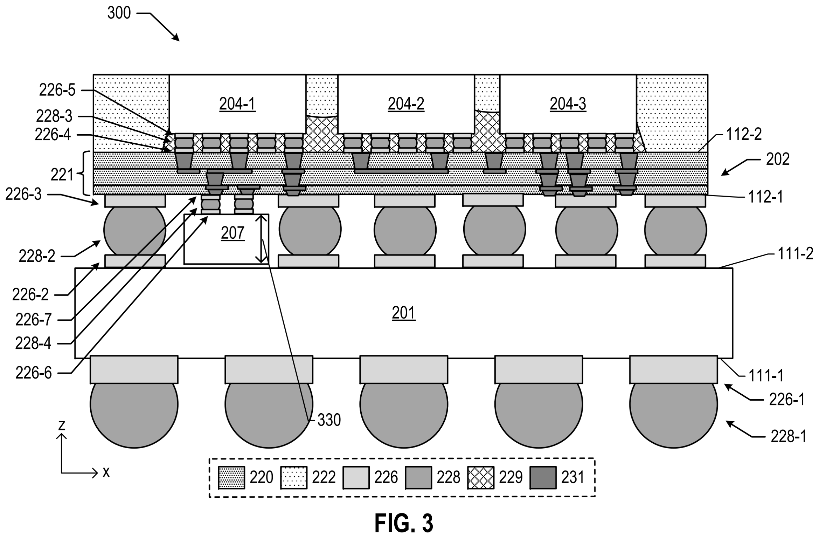

The dies attached to the bottom side of the interposer may be arranged to enable desired interconnect placement (e.g., either the location of the conductive bumps 228-2, the location of interconnects between the dies attached to the backside of the interposer and the dies attached to the frontside of the interposer, or other interconnects). In some examples, a die attached to the backside of the interposer may be below and aligned (e.g., substantially aligned) with one of the dies attached to the frontside of the interposer. For example, FIG. 3 illustrates an example of a microelectronic assembly 300 in which a die 207 attached to the face 112-1 of the interposer 202 is aligned with a die 204-1 attached to the face 112-2 of the interposer 202. In one such example, the die 207 attached to the backside of the interposer 202 and aligned with a die 204-1 attached to the frontside of the interposer 202 can be a die with circuitry directly supporting the die 204-1 attached to the frontside of the interposer 202. For example, the die 204-1 may include compute logic (e.g., a processor core, graphics processor, and/or other compute logic), and the die 207 may include one or more capacitors (e.g., decoupling capacitors), voltage regulator circuitry, power integrity circuitry, or other circuitry for the die 204-1. In some examples in which the die 207 includes a capacitor, the height or thickness 330 of the die 207 may be greater (e.g., greater than the thickness of a die without a capacitor), and may occupy the majority of the height of the bump field, as shown in FIG. 3. In one example, the height or thickness 330 of the die 207 may be in a range of about 15 to 80 microns, or about 40 to 60 microns, where the thickness 330 is a dimension of the die in a plane that is substantially orthogonal to the substrate 201 (e.g., along the z-axis as shown in FIG. 3). In examples in which the die 207 includes a capacitor, any suitable capacitor may be included in the die 207 (e.g., metal-insulator-metal (MIM) capacitors, thin film capacitors, and/or any other type of capacitor). In one example where the die 204-1 is or includes a processor (e.g., central processing unit (CPU), graphic processing unit (GPU), neural processing unit (NPU), or other processor), the die 207 may include memory coupled with the die 204-1. For example, the die 207 may include a memory array, such as SRAM or DRAM, to provide cache and/or system memory to the die 204-1.

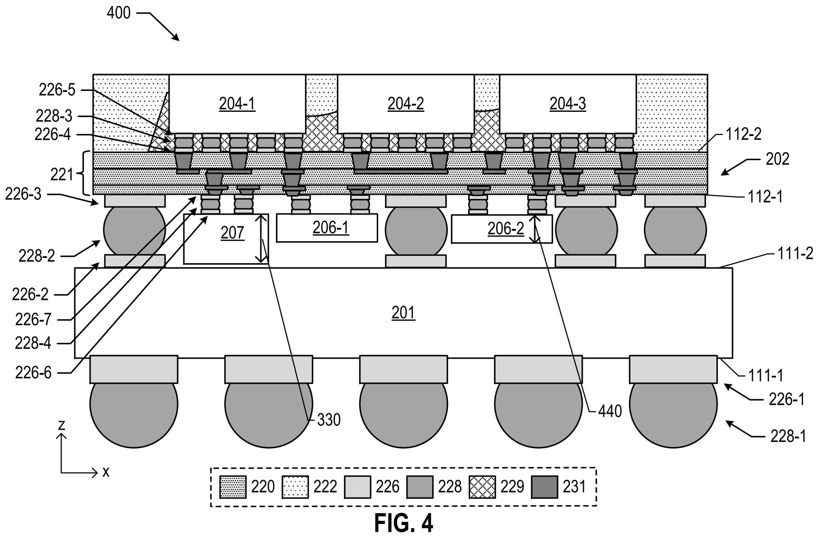

In some examples, dies having different heights may be in the bump field between the interposer 202 and the substrate 201. For example, FIG. 4 illustrates an example of a microelectronic assembly 400 that includes a die 207 with a first thickness 330 and a die 206-2 with a second thickness 440, where the thickness 440 of the die 206-2 is smaller than the thickness 330 of the die 207 (i.e., the thickness 330 is greater than the thickness 440). In one such example, the die 207 may include a capacitor, and the dies 206-1 and 206-2 may be, for example, bridge dies, memory dies, or other dies. Thus, in some examples, the dies 207, 206-1, and/or 206-2 may be different types of dies (e.g., dies that include different circuitry). In other examples, the dies 207, 206-1 and 206-2 may have about the same thickness.

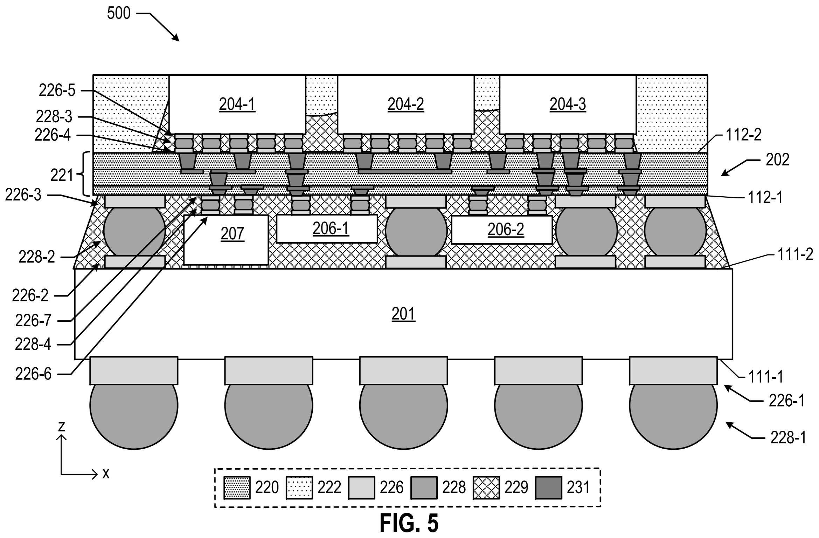

FIG. 5 illustrates another example of a microelectronic assembly 500 with dies in the bump field between the interposer and the substrate. The microelectronic assembly 500 is similar to the microelectronic assembly 400 of FIG. 4, with the difference of an underfill material 229 surrounding both the dies 206-1, 206-2, and 207 and the conductive bumps 228-2. As can be seen in the example illustrated in FIG. 5, the same underfill material 229 is between the dies 206-1, 206-2, and 207 and the interposer 202 and between the dies 206-1, 206-2, and 207 and the substrate 201. In one example, a thermally conductive underfill material may be used to facilitate heat transfer from the dies 206-1, 206-2, and 207. FIG. 5 shows an example in which the same underfill material 229 is disposed between the interposer and the substrate, and between the interposer and the dies 204-1, 204-2, and 204-3; however, in other examples, a different underfill material may be used in the bump field around the conductive bumps 228-2 and around the conductive bumps 228-3.

Thus, FIGS. 1A-1B and 2-5 illustrate examples in which the dies 206-1, 206-2, and 207 are in a same plane with the conductive bumps 228-2. One challenge with fitting dies in the bump field is that in order to accommodate the thickness of the dies, large conductive bumps may need to be used. For example, if the dies 206-1 and 206-2 or 207 have a thickness of about 50 microns, conductive bumps of about 150 microns may be used to ensure sufficient space for the dies. Large conductive bumps can limit the number of interconnects that can be formed between the interposer 202 and the substrate 201. In one example, to address the challenges associated with large conductive bumps between the interposer 202 and the substrate 201, the assembly may include conductive pillars coplanar with the dies 206-1, 206-2, and 207, which have a relatively narrow width compared to the conductive bumps 228-2.

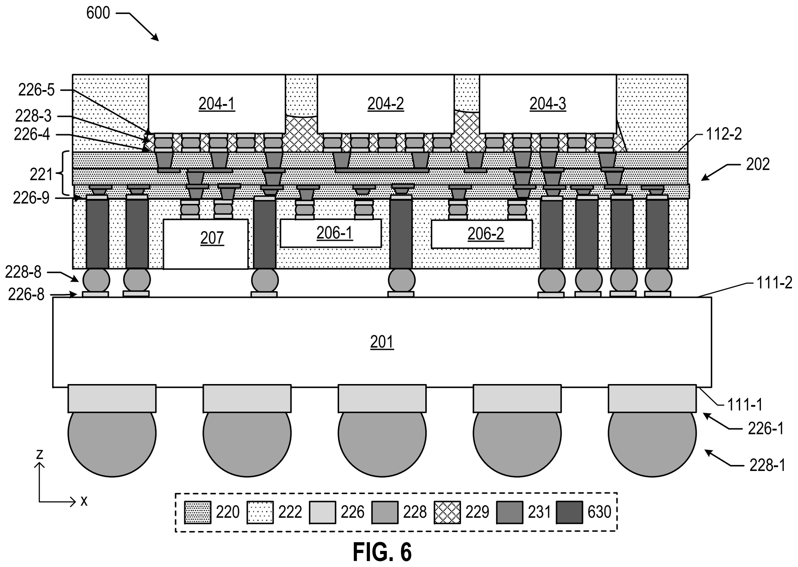

For example, FIG. 6 illustrates an example microelectronic assembly 600 that includes conductive vias or pillars 630 extending between the interposer 202 and the substrate 201 coplanar with the dies 206-1, 206-2, and 207. In the example illustrated in FIG. 6, the conductive pillars 630 are coupled with conductive contacts 226-9 at the back side of the interposer 202. In one such example, the conductive contacts 226-9 may be in the dielectric material (e.g., recessed in the interposer 202), such as shown in FIG. 6. In one such example, smaller conductive bumps 228-8 may be provided between the conductive pillars 630 and the conductive contacts 226-8 on the substrate 201. In one example, the conductive pillars 630 may include any suitable conductive material, such as copper (Cu), aluminum (Al), tungsten (W), or cobalt (Co), and/or any other suitable conductive material. The conductive bumps may be, for example, solder balls. In the example illustrated in FIG. 6, the molding material 222 surrounds the dies 206-1, 206-2 and 207 and the conductive pillars 630. Thus, in the example illustrated in FIG. 6, there is a dielectric material (e.g., the molding material 222) at least partially around the dies 206-1, 206-2, and 207, and a conductive pillar 630 extends through the dielectric material and is coupled with one of the conductive bumps 228-8 on one side and a conductive interconnect (e.g., a conductive contact 226-9 or other conductive interconnect in an RDL 221) of the interposer 202, where the dies 206-1, 206-2, and 207 are in a same plane as the conductive pillar 630. In one such example, the molding material may be absent from the face or side of one or more of the dies 206-1, 206-2, and 207 that faces the substrate 201 (e.g., there may be an airgap between the die 207 and the substrate 201 in FIG. 6).

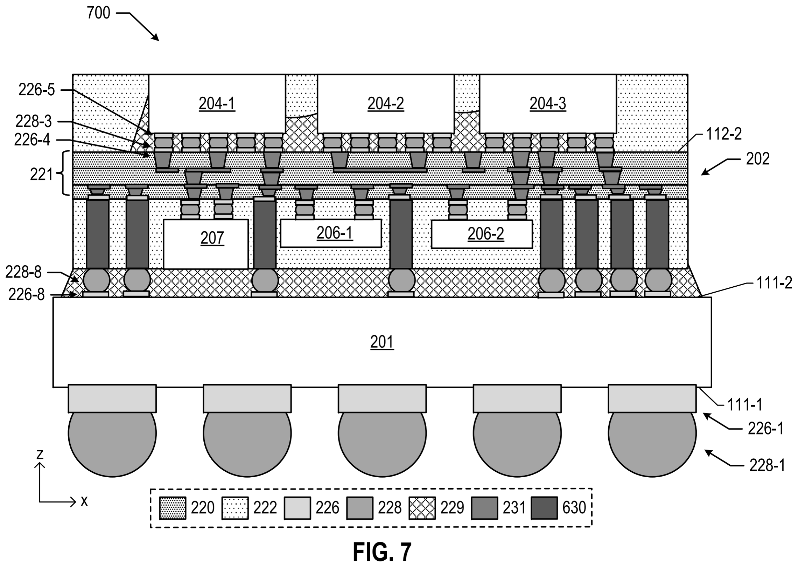

FIG. 7 illustrates another example of a microelectronic assembly 700 that includes conductive pillars extending between the interposer 202 and the substrate 201 coplanar with the dies 206-1, 206-2, and 207. The microelectronic assembly 700 of FIG. 7 is similar to the microelectronic assembly 600 of FIG. 6, but differs in that an underfill material 229 is present between adjacent bumps 228-8 and between the molding material 222 and the substrate 201 (e.g., between the dies 206-1, 206-2, and 207 and the substrate 201, and between a portion of the molding material 222 and the substrate 201). In one such example, the molding material 222 is a first dielectric material, and the underfill material 229 is a second dielectric material with a different material composition from the first dielectric material. In other examples, the molding material 222 and the underfill material 229 may have similar or the same material compositions.

Thus, FIGS. 1A-1B and 2-7 illustrate examples of microelectronic assemblies with disaggregated dies coupled with a backside of an interposer that is over and coupled with a substrate. In one such example, conductive interconnects (e.g., bumps and/or pillars) are between and coupled with the substrate and the interposer. One or more first dies are over and bonded with a first side (e.g., front side) of the interposer, and one or more second dies are below and bonded with a second side (e.g., back side) of the interposer opposite the first side. In one such example, the second dies are between the substrate and the interposer and coplanar with the conductive interconnects. In one example, the second dies are TSV-less, e.g., the conductive contacts on the second dies are limited to a side of the second dies facing the second side (e.g., back side) of the interposer (e.g., one or more of the second dies may lack a via that extends from a first face of die to the second face of the die).

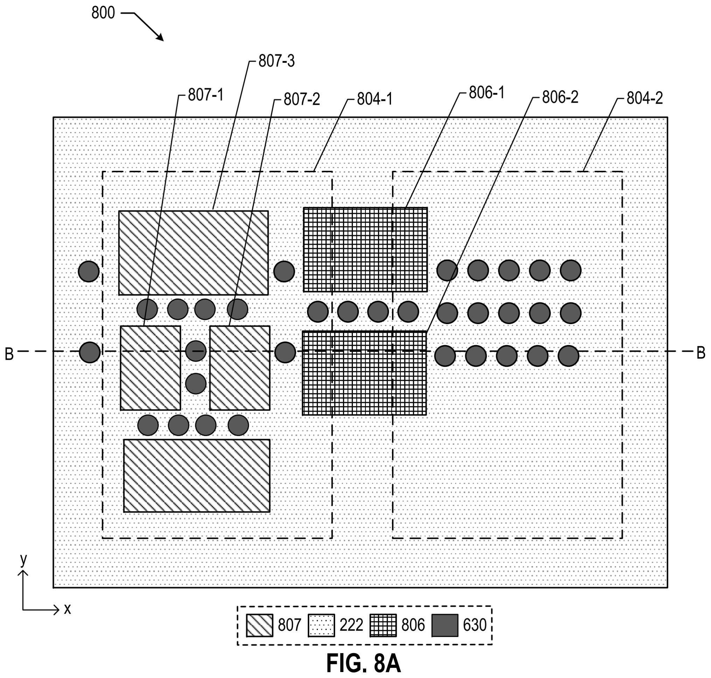

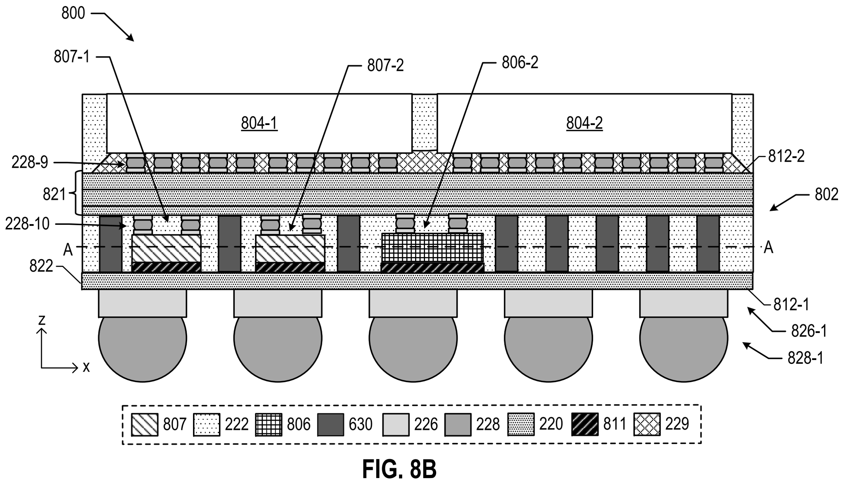

FIGS. 8A-8B illustrate different cross-sectional views of another example of a microelectronic assembly with disaggregated components, according to some embodiments of the present disclosure. FIG. 8A illustrates a cross-section in the x-y plane of the example coordinate system shown in FIGS. 8A-8B along a plane AA shown in FIG. 8B. FIG. 8B illustrate a cross-section in the x-z plane of the example coordinate system shown in FIGS. 8A-8B along a plane BB shown in FIG. 8A.

Turning first to FIG. 8A, the microelectronic assembly 800 includes dies 807 and dies 806 that are embedded in an interposer. In one example, a die may be embedded in an interposer if the die is between a first layer of a dielectric material (e.g., a first RDL) and a second layer of a dielectric material (e.g., a second RDL) of an interposer. For example, FIG. 8B, discussed below, illustrates an interposer 802 with RDLs 821 and 822. In one such example, a different insulator material, such as a molding compound, may at least partially surround the embedded dies between the RDLs of the interposer. For example, in the perspective shown in FIG. 8A, the dies 806 and 807, which are between layers of dielectric material of an interposer (e.g., between RDLs), are at least partially surrounded by a molding material 222. IC dies may be attached to the interposer (e.g., over a top or front side of the interposer). For example, IC dies 804-1 and 804-2 (the locations of which are shown with dashed line boxes in FIG. 8A) are over and coupled with an interposer. The dies 804-1 and 804-2 may be examples of the dies 204-1, 204-2, and 204-3, discussed above.

In the example illustrated in FIGS. 8A-8B, some of the embedded dies are split components that are distributed across multiple embedded dies. For example, the dies 806-1 and 806-2 may be two separate dies used to implement a bridge die. Similarly, the dies 807-1 and 807-2 may be two separate dies that include capacitors. Distributing the circuitry across multiple smaller embedded dies can enable additional area for placing conductive vias through the interposer. In the example illustrated in FIG. 8A, conductive vias or pillars 630 are between and coplanar with adjacent dies 806-1 and 806-2 and between and coplanar with the adjacent dies 807-1 and 807-2. In some examples, the dies 806-1, 806-2, 807-1, and 807-2 may have conductive pillars 630 adjacent to two or more sides of the dies. For example, the die 807-2 has conductive pillars 630 adjacent to all four side of the die 807-2. In contrast, the die 807-3 represents a die with a capacitor which is not split across multiple dies.

FIG. 8B illustrates a cross-sectional side view of the microelectronic assembly 800 that includes the interposer 802. The interposer 802 has a first side or face 812-1 (e.g., a bottom or back side) and a second side or face 812-2 (e.g., a top or front side) that is opposite the face 812-1. In one example, the interposer 802 may include conductive contacts 826-1 on the face 812-1, where the conductive contacts 826-1 coupled with conductive bumps 828-1. The conductive bumps 828-1 may couple with conductive contacts on another substrate or circuit board (such as the substrate 201, described above). In another example, the interposer 802 may couple with another substrate or circuit board via a socket. As can be seen in FIG. 8B, the dies 804-1 and 804-2 are over and coupled with the interposer 802 with conductive bumps 228-9, which are between conductive pads 226. An underfill material 229 is at least partially around the conductive bumps 228-9 and a molding material 222 at least partially surrounds the dies 804-1 and 804-2 and is over the underfill material 229.

In the example illustrated in FIG. 8B, the dies 807-1, 807-2, and 806-2 are between RDLs of the interposer 802 (e.g., between one of the RDLs 821 and the RDL 822). The dies 807-1, 807-2, and 806-2 are coupled with interconnects in an RDL 821 above/over the dies 807-1, 807-2, and 806-2 via conductive bumps 228-10, which are between conductive pads 226. The molding material 222 is at least partially around and between the dies 807-1, 807-2, and 806-2. In some examples, the dies 807-1, 807-2, and 806-2 are TSV-less in the sense that they lack vias that extend entirely through the dies from one face of the dies to the opposite face. For example, electrical interconnects/signal pathways between the dies 807-1, 807-2, and 806-2 and the interposer 802 are limited to a region between the dies 807-1, 807-2, and 806-2 and the RDLs 821 of the interposer 802 (e.g., there are no electrical/signal interconnects between the bottom of the dies 807-1, 807-2, and 806-2 and the bottom RDL 822 of the interposer). In the example illustrated in FIG. 8B, an adhesive material 811 (such as a die attach film) or other material may be present between the dies 807-1, 807-2, and 806-2 and the RDL 822. Although the example illustrated in FIG. 8B shows that the molding material is not present between dies 807-1, 807-2, and 806-2 and the RDL 822, in other examples, a region between the dies 807-1, 807-2, and 806-2 and the RDL 822 may include a continuous portion of the molding material 811. In one such example, conductive interconnects (e.g., conductive vias) are absent between the dies 807-1, 807-2, and 806-2 and the RDL 822.

Thus, FIGS. 8A-8B illustrate another example of a microelectronic assembly 800 which may include dies below interposer layers, where the dies lack conductive vias that extend entirely through the dies. In some examples, the assembly may include multiple dies embedded between RDLs (e.g., multiple interconnect/bridge dies, multiple dies with capacitors, etc.), where conductive interconnects (e.g., bumps and/or pillars) are coplanar with and between adjacent embedded dies.

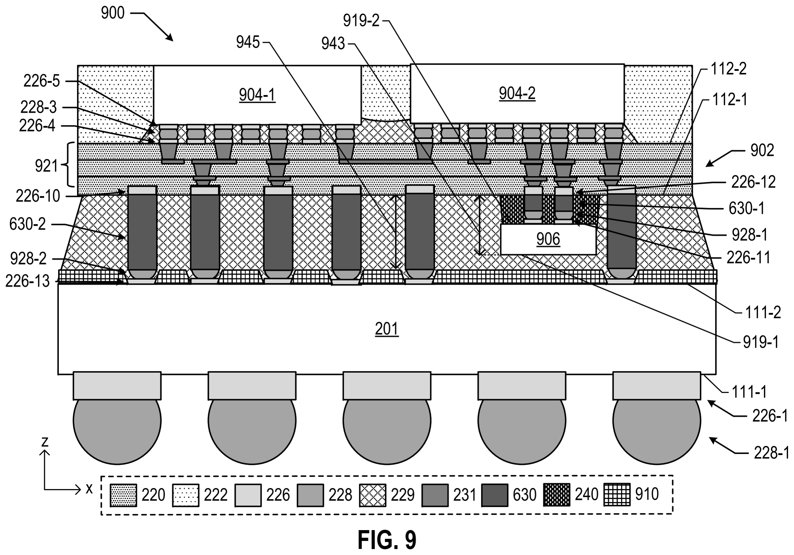

FIG. 9 illustrates a cross-sectional side view of another example of a microelectronic assembly 900 with disaggregated components. The microelectronic assembly 900 of FIG. 9 a die 906 attached to a backside of an interposer 902 in a bump field of conductive pillars 630 between the interposer 902 and the substrate 201, similar to the microelectronic assembly 600 of FIG. 6 and the microelectronic assembly 700 of FIG. 7. The die 906 may be an example of the dies 206-1, 206-2, 207, and the interposer 902 may be an example of the interposer 202, discussed above. One difference between the microelectronic assemblies 600 and 700 of FIGS. 7 and 7 and the microelectronic assembly 900 of FIG. 9 is that the die 906 of FIG. 9 is coupled with the face 112-1 the interposer 902 with conductive pillars 630-1, which may result in a taller height of the die 906 relative to the interposer 902 (e.g., a larger distance between the side or face 919-1 of the die 906 and the face 112-1 of the interposer). For example, as can be seen in FIG. 9, the microelectronic assembly 900 includes conductive pillars 630-1 between the conductive contacts 226-12 in the interposer 902 and conductive contacts 226-11 on the face 919-2 of the die 906. In the example illustrated in FIG. 9, the conductive contacts 226-12 that are in contact with the conductive pillars 630-1 are recessed in an RDL 921 if the interposer 902 (e.g., the conductive contacts 226-12 are coplanar with the dielectric material of an RDL 921 of the interposer 902). In the example illustrated in FIG. 9, a solder cap 928-1 is between the pillar 630-1 and the conductive contact 226-11 on the face 919-2 of the die 906.

As can be seen in FIG. 9, the height of the die 906 relative to the face 112-1 of the interposer 902 may be greater than if solder balls of the same width were used to couple the die 906 to the face 112-1 of the interposer 902. For example, the die 906 has a face 919-2 facing the interposer and a face 919-1 opposite the face 919-2, and the face 919-1 is at distance 943 from the interposer 902. In one such example, tall pillars 630-2 may be used to make room for the height of the die 906, where the height 945 of the pillars 630-2 is greater than the distance 943. For example, a conductive pillar 630-2 has a first end coupled with a conductive contact 226-10 in the interposer 902 and a second end opposite the first end and coupled with a conductive contact 226-13 on the substrate 201. In one such example, the second end of the pillar 630-2 coupled with the substrate is at a distance from the interposer 902 that is greater than the distance 943 of the face 919-1 of the die 906 from the interposer 902.

Additionally, another difference of the microelectronic assembly 900 compared to the microelectronic assemblies 600 and 700 is that the microelectronic assembly 900 lacks solder balls between the conductive pillars 630-2 and the conductive contacts 226-13 on the substrate 201; instead, the conductive pillars 630-2 are capped with solder caps 928-2, which are coupled with the conductive contacts 226-13 on the substrate 201. Similar to the conductive contacts 226-12, the conductive contacts 226-10 in contact with the conductive pillars 630-2 may be recessed in an RDL 921 of the interposer 902. The solder caps 928-2 are in contact with conductive contacts on the face 111-2 of the substrate 201. The microelectronic assembly 900 includes a solder mask 910, where the conductive contacts 226-13 are in openings in the solder mask 910. The solder mask 910 may include any suitable solder mask material, such as an epoxy-based material, a dry film, a UV-curable solder mask material, or any other suitable solder mask material.

Like solder balls, solder caps are portions of a solder material between and coupling two conductive elements. Solder caps typically differ from solder balls in the shape and height or thickness. Solder balls typically have a round (e.g., circular or oval) cross-sectional shape prior to heating in a reflow process to form a solder joint. After reflow, the solder ball in the solder joint may still have a relatively rounded shape (e.g., a cross-sectional shape of a solder ball in a solder joint may have sides that are round or curved and convex). In other examples, the cross-sectional shape of a solder ball in a solder joint may have substantially straight sides. In some examples, solder caps may have a semicircle or rectangular cross-sectional shape. The height or thickness of a solder ball is typically greater than the height or thickness of a solder cap relative to total height or thickness of the solder joint or relative to the thickness of the conductive contacts (e.g., pads) with which the solder portion is coupled. Additionally, the percent of cross-sectional area of a solder joint that is solder is typically greater in a solder joint with a solder ball than a solder joint with a solder cap. For example, a solder joint that includes a solder ball typically includes the solder ball between two conductive pads. In one such example, the solder ball may be thicker than the conductive pads, and the majority of the cross-sectional area of such a solder joint may be occupied by the solder material. In contrast, a solder cap may be applied to the end of another conductive bump (such as a copper pillar or other conductive bump). In one such example, the height or thickness of the solder cap may be smaller than the height or thickness of the conductive bump. In other examples, the height or thickness of a solder cap may be about the same as, or greater than, the height of the conductive bump.

In the example illustrated in FIG. 9, the solder caps 928-1 and 928-2 have a semicircle cross-sectional shape and have a thickness that is significantly smaller than the height of the respective conductive pillars 630-1 and 630-2. For example, the thickness of the conductive caps 928-2 is less than about 10% of the height of the conductive pillars 630-2, where the thickness or height of the conductive caps is a dimension of those elements in a plane substantially orthogonal to the substrate 201, e.g., along the z-axis. In the example illustrated in FIG. 9, an underfill material is present around the conductive pillars 630-2 and around the conductive pillars 630-1. For example, the microelectronic assembly 900 includes an underfill material 240 between the die 906 and the interposer 902 and at least partially around the conductive pillars 630-1, and an underfill material 229 between the interposer 902 and the substrate 201, and at least partially around the conductive pillars 630-2. The underfill material 240 and the underfill material 229 may have the same material composition, or different material compositions. For example, the underfill material 240 may include a material with a higher viscosity than the underfill material 229.

Thus, FIG. 9 illustrates an example microelectronic assembly 900 with conductive pillars between and coupled with the die 906 and the interposer 902, and tall conductive pillars 630-2 between and coupled with the interposer 902 and the substrate 201. In one such example, the die (e.g., the face 919-1 of the die 906) may be at a distance of about 5 to 20 microns from the substrate 201. Although FIG. 9 shows an example in which the conductive pillars 630-1 have a narrower width and pitch than the conductive pillars 630-2 (which may enable a higher number of interconnects between the die 906 and the dies 904-1 and/or 904-2), in other examples, the conductive pillars 630-1 and 630-2 may have about the same width and/or pitch.

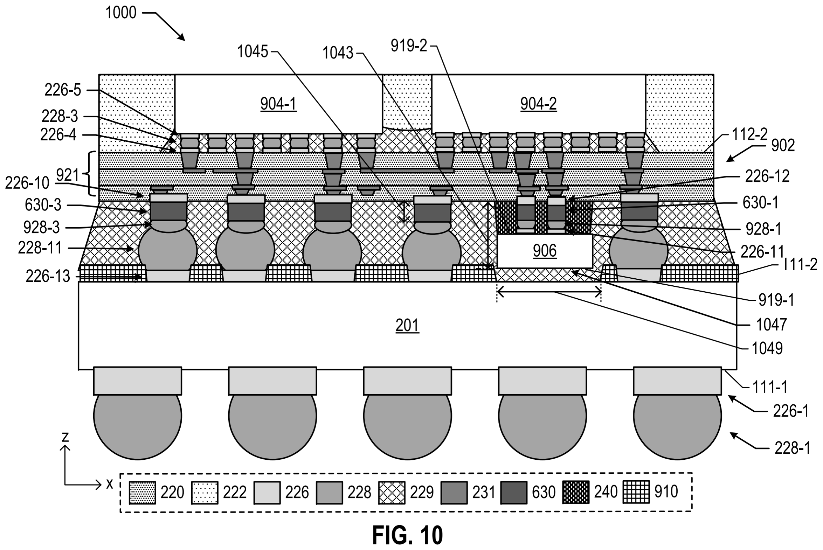

FIG. 10 illustrates a cross-sectional side view of another example of a microelectronic assembly 1000 with disaggregated components. The microelectronic assembly 1000 includes a die 906 coupled with a back side of an interposer 902 with conductive pillars 630-1 similar to the microelectronic assembly 900 of FIG. 9. One difference between the microelectronic assembly 900 and the microelectronic assembly 1000 is that the microelectronic assembly 1000 includes shorter solder-capped conductive pillars 630-3 and solder balls 228-11 between the interposer 902 and the substrate 201, instead of the tall conductive pillars 630-2 shown in FIG. 9.

As can be seen in the example illustrated in FIG. 10, the height of the die 906 relative to the back side of the interposer 902 is greater than the height 1045 of the conductive pillars 630-3. In other words, a face 919-1 of the die 906 facing away from the interposer 902 is at a distance 1043 from the face 112-2 of the interposer 902, and the height 1045 of one of the conductive pillars 630-3 is smaller than the distance 1043. For example, a pillar of the conductive pillars 630-3 has a first end coupled with one of the conductive contacts 226-10 and a second end opposite the first end (e.g., where the second end of the conductive pillar 630-3 is capped with a solder cap 928-3), where the second end of the conductive pillar 630-3 is at a distance (e.g., height 1045) from the face 112-1 of the interposer 902, and where the distance of the second end of the conductive pillar 630-3 is less than the distance 1043 (e.g. the height of the pillars 630-3 relative to the back side of the interposer 902 is smaller than the height of the die 906 relative to the back side of the interposer 902).

In the example illustrated in FIG. 10, the microelectronic assembly 1000 further includes solder balls 228-11 between the conductive pillars 630-3 and the conductive contacts 226-13 on the substrate 201, where solder balls 228-11 are absent in the region of the die 906. Thus, a cavity between adjacent solder balls 228-11 may be formed to accommodate the die 906. In the example illustrated in FIG. 10, the die 906 is in a same plane as the solder balls 228-11. The solder balls 228-11 are in contact with the solder caps 928-3. The solder balls 228-11 and the solder caps 928-3 may have substantially the same material compositions, or different material compositions. Regardless of whether the material composition of the solder balls 228-11 and the solder caps 928-3 are the same or different, an interface may be visible between the solder balls 228-11 and the solder caps 928-3. Thus, in the microelectronic assembly 900 after reflow, a solder joint formed from the solder cap 928-3 and the solder ball 228-11 between the conductive pillar 630-3 and the conductive contact 226-13 may include a first solder portion (e.g., a portion of solder from the solder cap 928-3) and a second solder portion (e.g., a portion of solder form the solder ball 228-11), where the first solder portion has a smaller thickness than the second solder portion.

The microelectronic assembly 1000 also includes a solder mask 910 where the conductive contacts 226-13 and a portion of the solder balls 228-11 are in openings in the solder mask 910. In the example illustrated in FIG. 10, the solder mask 910 has an opening 1047 substantially aligned with the die 906, where at least a portion of the die 906 is in the opening 1047. As can be seen in FIG. 10, the opening 1047 includes a portion of the underfill material 229 coplanar with the solder mask 910 and coplanar with other openings in the solder mask 910 in which the conductive contacts 226-13 are disposed. The underfill material 229 may be disposed both under and around the sides of the die 906, such that the underfill material is between the die 906 and sidewalls of the opening 1047. In the example illustrated in FIG. 10, the underfill material 229 is absent in the opening 1047, and therefore the underfill material 229 is between and in contact with the substrate 201 and the die 906. In the example illustrated in FIG. 10, the width 1049 of the opening 1047 is greater than or about to equal to the width of the die 906 (where the width 1049 of the opening 1047 is a dimension of the opening 1047 substantially parallel with the substrate 201, e.g., along the x-axis or y-axis as shown in FIG. 10, where the y-axis is going into and coming out of the page). In one such example, a face 919-1 of the die 906 may be coplanar with the solder mask 910. In other examples, the solder mask 910 may still be present between the 906 and the substrate 201.

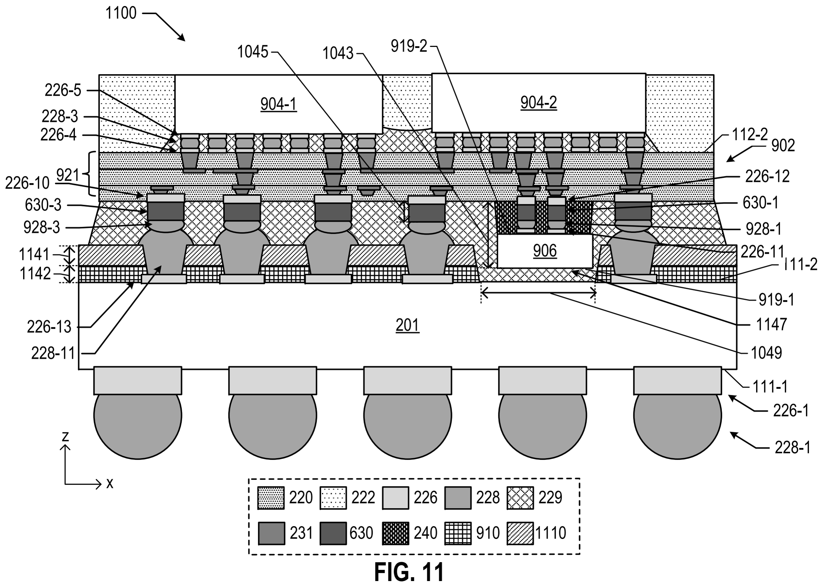

FIG. 11 illustrates a cross-sectional side view of another example of a microelectronic assembly 1100 with disaggregated components. The microelectronic assembly 1100 includes a die 906 coupled with a back side of an interposer 902 with conductive pillars 630-1 similar to the microelectronic assembly 1000 of FIG. 10, and solder-capped conductive pillars 630-3 and solder balls. One difference between the microelectronic assembly 1000 and the microelectronic assembly 1100 is that the microelectronic assembly 1100 includes a further layer of an insulator material 1110 on the solder mask 910. Thus, in the example illustrated in FIG. 10, a layer of the insulator material 1110 is between and in contact with the solder mask 910 and the underfill material 229. In some examples, the insulator material 1110 may be a dry film, such as a dry resist film. In some examples, the combined thickness of the solder mask 910 and the insulator material 1110 may be in a range of about 30 to 55 microns, or about 35 to 50 microns. In one such example, the solder mask 910 may have a thickness 1142 of about 20 microns (or in a range of about 15 to 30 microns) and the layer of the insulator material 1110 may have a thickness 1141 of about 15 to 30 microns. Thus, in some examples, the thickness 1141 of the insulator material 1110 may be about the same as, smaller than, or greater than the thickness 1142 of the solder mask 910. In one example, the combined thicknesses 1141 and 1142 may be about 60-75% the height of the solder balls 228-11.

As can be seen in FIG. 11, the microelectronic assembly 1100 includes an opening 1147 in the solder mask 910 and in the insulator material 1110, where the opening 1147 is substantially aligned with the die 906, where at least a portion of the die 906 is in the opening 1147. As can be seen in FIG. 11, the opening 1047 includes a portion of the underfill material 229 coplanar with the solder mask 910, coplanar with the insulator material 1110 and coplanar with other openings in the solder mask 910 in which the conductive contacts 226-13 are disposed. The underfill material 229 may be disposed both under and around the sides of the die 906, such that the underfill material is between the die 906 and sidewalls of the opening 1147 (e.g., between the die 906 and the insulator material 1110 and the solder mask 910 at the sidewalls of the opening 1147). In the example illustrated in FIG. 11, both the underfill material 229 and the insulator material 1110 are absent in the opening 1147, and therefore the underfill material 229 is between and in contact with the substrate 201 and the die 906. Like in FIG. 10, in the example illustrated in FIG. 11, the width 1049 of the opening 1147 is greater than or about to equal to the width of the die 906 (where the width 1049 of the opening 1147 is a dimension of the opening 1147 substantially parallel with the substrate 201, e.g., along the x-axis or y-axis as shown in FIG. 11, where the y-axis is going into and coming out of the page). In one such example, a face 919-1 of the die 906 may be coplanar with the solder mask 910 or coplanar with the insulator material 1110. In some examples, the die 906 is coplanar with both the solder mask 910 and the insulator material 1110. In other examples, the solder mask 910 may still be present between the 906 and the substrate 201.

Although FIG. 11 illustrates two distinct layers of material (the solder mask 910 and an insulator material 1110 such as a dry resist film), in other examples, the insulator material 1110 may include a thick layer of the solder mask 910. For example, the thickness of the solder mask 910 may be the combined thickness 1141 and 1142 shown in FIG. 11. In one such example, the solder mask 910 may have a thickness in a range of about 30 to 55 microns, or about 35 to 50 microns. In one example, the thickness of the solder mask 910 may be about 60-75% the height of the solder balls 228-11.

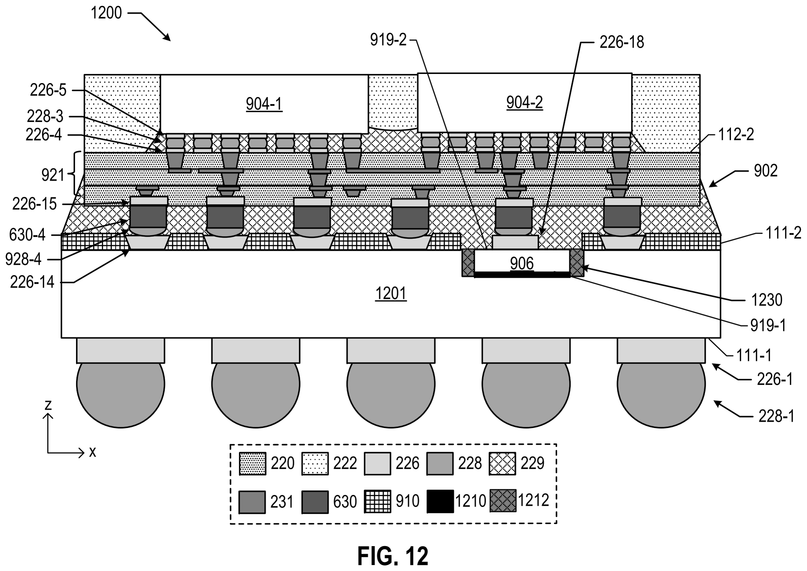

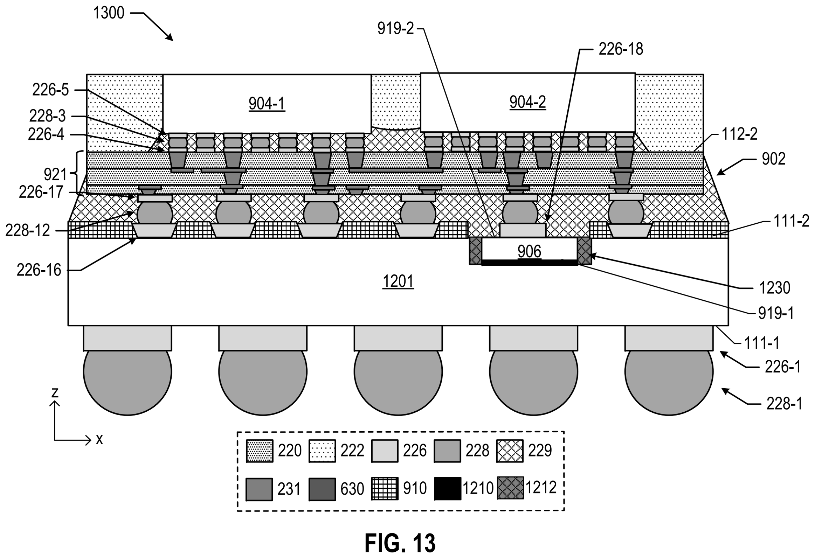

FIGS. 12 and 13 illustrate examples of microelectronic assemblies 1200 and 1300 with disaggregated components in which the die 906 is embedded in the substrate 201. The microelectronic assemblies 1200 and 1300 include a substrate 1201, an interposer 902 over the substrate 1201, and conductive bumps (e.g., bumps or pillars, etc.) between and coupled with the substrate 1201 and the interposer 902. The substrate 1201 includes a recessed region or opening 1230 and the die 906 in the opening 1230. The die 906 has a first face 919-1 that is facing and attached to the substrate 1201 and a second face 919-2 opposite the first face 919-1, where the second face 919-2 is facing and coupled with the interposer 902. In the example illustrated in FIGS. 11 and 12, the face 919-1 of the die 906 is substantially flush or coplanar with the non-recessed regions of the substrate 1201. Thus, the die 906 is coplanar with the substrate 1201 (e.g., coplanar with an insulator material of the substrate 1201) and the face 919-2 may not protrude from the opening 1230.

In one example, the microelectronic assemblies 1200 and 1300 may include an adhesive material 1210 between the die 906 and the substrate 1201. The adhesive material 1210 may include, for example, a die attach film, or other material to adhere the die 906 to the substrate 1201 in the opening 1230. The microelectronic assemblies 1200 and 1300 may further include an insulator material 1212, such as an underfill material, a molding material, or other insulator material that may provide structural support to the die 906 (e.g., prior to attaching the interposer and providing the underfill material 229, such as during shipping of the substrate 1201 with the embedded die 906). In the illustrated example, the insulator material 1212 may surround the die 906 along the edges. For example, the insulator material 1212 may be present between the substrate 1201 (e.g., sidewalls of the opening 1230) and edges of the die 906.

One difference between the microelectronic assemblies 1200 and 1300 is the type of interconnect between the interposer 902 and the substrate 1201. The microelectronic assembly 1200 of FIG. 12 includes conductive pillars 630-4 between and coupled with the substrate 1201 and the interposer 902. In the example illustrated in FIG. 12, the conductive pillars are capped with solder caps 928-4, which are coupled with the conductive contacts 226-14. Thus, the conductive pillars 630-4 are between the conductive contacts 226-15 and the solder caps 928-4. The conductive pillars 630-4 may be shorter than the pillars in some of the previous examples due to the location of the die 906 within the cavity or opening 1230 at the top surface the substrate 1201. FIG. 13 illustrates an example microelectronic assembly 1300 that includes conductive bumps that include solder balls/bumps 228-12 between conductive contacts 226-17 on the face 112-1 of the interposer 902 and conductive contacts 226-16 on the substrate 1201.

The microelectronic assemblies 1200 and 1300 include one or more conductive contacts 226-18 on a face 919-2 of the die 906. In the example illustrated in FIGS. 12 and 13, due to the die 906 being disposed in a recessed region of the substrate, the conductive contacts 226-18 may be coplanar with the solder mask 910 and coplanar with other conductive contacts 226-14 (FIG. 12) and conductive contacts 226-16 (FIG. 13). Although a single conductive bump (e.g., single conductive pillar 630-4 and single solder ball/conductive bump 228-12) is shown as coupled with a contact 226-18 on the die 906, a plurality of conductive bumps may be coupled with the face 919-2 of the die 906. Also, although FIGS. 12 and 13 show the width and pitch of the conductive pillars 630-4 and the solder balls/bumps 228-12 coupled with the substrate 1201 and coupled with the die 906 as being about the same, in other examples, the conductive bumps coupled with the die 906 may be narrower and/or have a narrower pitch than the conductive bumps between and coupled with the substrate 1201 and the interposer 902.

In the example illustrated in FIGS. 12 and 13, an underfill material 229 is at least partially around the conductive bumps between the interposer 902 and the substrate 1201. For example, referring to FIG. 12, the underfill material 229 is around the conductive pillars 630-4 between the interposer 902 and the substrate 1201. Similarly, in FIG. 13, the underfill material 229 is around the conductive bumps 228-12 between the interposer 902 and the substrate. The underfill material 229 may be over the die 906 and over portions of the insulator material 1212. The underfill material 229 may also surround one or more conductive contacts between the top side (e.g., the face 919-2) of the die 906 and a corresponding conductive bump or pillar that couples the die 906 with the interposer 902.

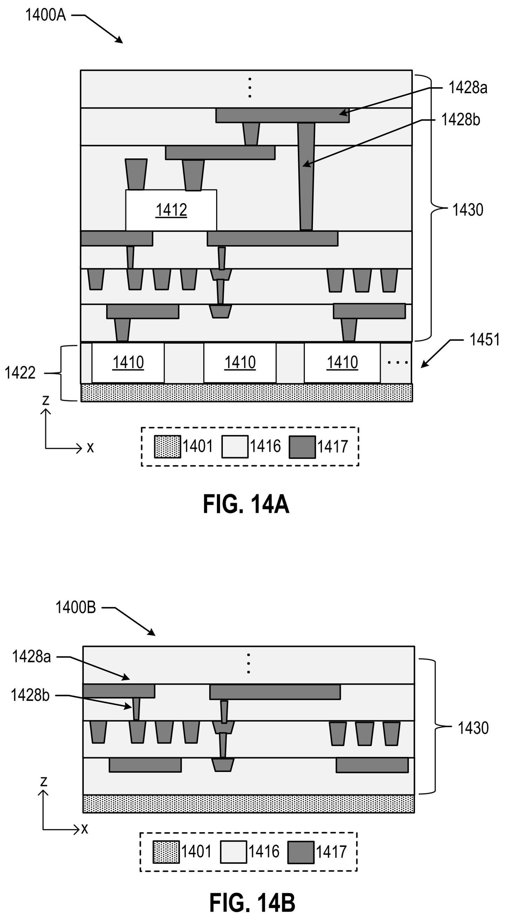

FIGS. 14A-14B illustrate cross-sectional side views of examples of dies which may be included on the backside of an interposer and coplanar with conductive bumps and/or vias (such as the dies 206-1, 206-2, and 207 of FIGS. 1A-1B and FIGS. 2-7 or the die 906 of FIGS. 9-13), or which may be embedded in an interposer (such as the dies 807-1, 807-2, and 806-2 of FIGS. 8A-8B).

FIGS. 14A and 14B illustrate examples of dies 1400A and 1400B that includes a plurality of interconnect layers 1430 over a substrate 1401. The substrate may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some examples, the substrate 1401 may be thinned (e.g., polished, etched, or otherwise removed).

In one example, the conductive interconnects 1417 of the dies 1400A and 1400B are in interconnect layers 1430 over the substrate 1401. The interconnect layers 1430 may also be referred to as back end of line (BEOL) layers. In one example, each of the interconnect layers 1430 includes a plurality of interconnects electrically coupled to (e.g., in electrically conductive contact with) one or more conductive contacts on a top face of the die. Various interconnect layers 1430 may be/include one or more metal layers of a metallization stack. Various metal layers of the interconnect layers 1430 may be used to interconnect conductive contacts with one another, and thus interconnect IC dies (e.g., the dies 206-1, 206-2, and 206-3 of FIGS. 1A-1B) that are coupled with an interposer. In some examples (such as in FIG. 14A), one or more interconnect layers 1430 may interconnect various inputs and outputs of the devices 1410 (e.g., logic devices) in the device regions 1451 with one another, or with conductive contacts on the top face of the dies. In one example, each of the interconnect layers 1430 may include vias and lines/trenches. For example, a metal layer of the interconnect layers 1430 includes a via portion 1428b and a line or trench/interconnect portion 1428a. The trench portion 1428a of a metal layer is configured for transferring signals and power along electrically conductive (e.g., metal) lines (also sometimes referred to as "trenches") extending in the x-y plane (e.g., in the x or y directions), while the via portion 1428b of a metal layer is configured for transferring signals and power through electrically conductive vias extending in the z-direction, e.g., to any of the adjacent metal layers above or below. Although the dies 1400A and 1400B include conductive vias/via portions 1428b, they may be considered TSV-less because they lack vias that extend through the substrate 1401 and between the top and bottom faces of the dies.

Accordingly, in one example, vias connect metal structures (e.g., metal lines or vias) from one layer to metal structures of an adjacent layer. While referred to as "metal" layers, various layers of the interconnect layers 1430 may include only certain patterns of conductive metals, e.g., copper (Cu), aluminum (Al), tungsten (W), or cobalt (Co), or metal alloys, or more generally, patterns of an electrically conductive material, formed in an insulating medium such as an interlayer dielectric (ILD) 1416. The insulating medium may include any suitable ILD materials such as silicon oxide, carbon-doped silicon oxide, silicon carbide, silicon nitride, aluminum oxide, and/or silicon oxynitride. In some embodiments, the ILD 1416 disposed between the interconnect structures in different ones of the interconnect layers may have different compositions; in other embodiments, the composition of the ILD 1416 between different interconnect layers may be the same. A die may include more or fewer interconnect layers than shown in FIGS. 14A-14B, as indicated by the ellipses in the top interconnect layer 1430.

FIGS. 14A and 14B differ in that FIG. 14A illustrates an example of a die 1400A that may include devices 1410 and/or capacitors, and FIG. 14B illustrates an example of a die 1400B that includes only passive interconnect layers. For example, the die 1400A of FIG. 14A includes a device region 1451 over the substrate 1401. In one example, the device regions 1451 may include frontend devices 1410 (e.g., frontend transistors such as FinFETs, nanowire transistors, nanoribbon transistors, frontend memory cells, or other frontend devices). The device region 1451 and the substrate 1401 may also be referred to as front end of line (FEOL) layers 1422. The dies 1400A also includes a backend device or component 1412. In one example, the backend device or component 1412 may include a transistor, a memory cell, a capacitor, or other device or component.

In contrast, FIG. 14B illustrates an example of a passive die 1400B (e.g., a die without transistors). In the example illustrated in FIG. 14B, the interconnect layers 1430 are directly over the substrate 1401 without an intervening device layer (e.g., one of the interconnect layers 1430 is in direct contact with the substrate 1401). In one such example, transistors are absent from a layer directly over the substrate 1401 and also absent from the BEOL layers. Thus, the interconnect die 1400B can be referred to as a passive interconnect die or passive bridge die.

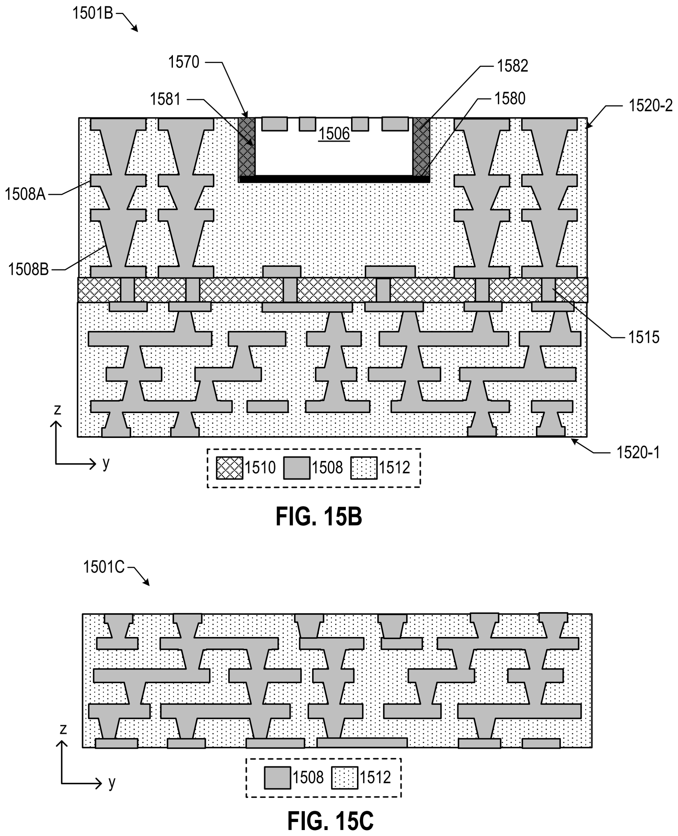

FIGS. 15A-15C are cross-sectional side views of substrates that may be included in microelectronic assemblies with disaggregated components as described herein. FIGS. 15A and 15B illustrate substrates 1501A and 1501B that include a core material with layers on either side of the core. FIG. 15C illustrates an example of a coreless substrate. FIG. 15B illustrates an example of a substrate 1501B in which the substrate has a cavity to accommodate an embedded die, such as shown in FIGS. 14A-14B.

Turning first to FIG. 15A, the substrate 1501A includes a dielectric material 1512 and a conductive material 1508 arranged in the one or more layers of the dielectric material 1512 to provide conductive pathways (e.g., conductive traces 1508A and conductive vias 1508B) through the substrate 1501A, as well as to provide conductive pads and contacts. The substrate 1501A may include a first surface 1520-1 and an opposing second surface 1520-2. The dielectric material 1512 of the substrate 1501A may be formed in layers. In some embodiments, the dielectric material 1512 may include an organic material, such as an organic buildup film. In some embodiments, the dielectric material 1512 may include a ceramic, an epoxy film having filler particles therein, glass, an inorganic material, or combinations of organic and inorganic materials, for example. In some embodiments, the conductive material 1508 may include a metal (e.g., copper). In some embodiments, the substrate 1501A may include layers of dielectric material 1512/conductive material 1508, with lines/traces/pads/contacts (e.g., conductive traces 1508A) of conductive material 1508 in one layer electrically coupled to lines/traces/pads/contacts (e.g., conductive traces 1508A) of conductive material 1508 in an adjacent layer by vias (e.g., 1508B) of the conductive material 1508 extending through the dielectric material 1512. Conductive traces 1508A may be referred to herein as "conductive lines," "conductive elements," "conductive pads," or "conductive contacts." A substrate 1501A including such layers may be formed using a PCB fabrication technique, for example. Although a particular number and arrangement of layers of dielectric material 112/conductive material 1508 are shown in various ones of the accompanying figures, these particular numbers and arrangements are simply illustrative, and any desired number and arrangement of dielectric material 112/conductive material 1508 may be used.

As shown in FIG. 15A, the substrate 1501A may further include a glass core 1510. The glass core 1510 may also be referred to as a layer of glass or a glass substrate. Layers of the dielectric material 1512 with conductive material 1508 may be present above and below the glass core 1510. In some examples, layers above the glass core may be coupled with, e.g., an interposer, such as the interposers 202, 802, and 902, discussed above. In some examples, the layers below the glass core may be coupled with, e.g., another package substrate or circuit board. As used herein, the term "glass core" refers to a layer (e.g., a glass layer) or a structure (e.g., a portion of a glass layer) of any glass material such as quartz, silica, fused silica, silicate glass (e.g., borosilicate, aluminosilicate, alumino-borosilicate), soda-lime glass, soda-lime silica, borofloat glass, lead borate glass, photosensitive glass, non-photosensitive glass, or ceramic glass. In particular, the glass core 1510 may be bulk glass or a solid volume/layer of glass, as opposed to, e.g., materials that may include particles of glass, such as glass fiber reinforced polymers (e.g., substrates/boards constructed of glass fibers and an epoxy binder). Such glass materials are typically non-crystalline, often transparent, amorphous solids. In some embodiments, the glass core 1510 may be an amorphous solid glass layer. In some embodiments, the glass core 1510 may include a material comprising silicon and oxygen, as well as any one or more of aluminum, boron, magnesium, calcium, barium, tin, sodium, potassium, strontium, phosphorus, zirconium, lithium, titanium, and zinc. In some embodiments, the glass core 1510 may include a material, e.g., any of the materials described above, with a weight percentage of silicon being at least about 0.5%, e.g., between about 0.5% and 50%, between about 1% and 48%, or at least about 23%. For example, if the glass core 1510 is fused silica, the weight percentage of silicon may be about 47%. In some embodiments, the glass core 1510 may include a material having at least 23% silicon and/or at least 26% oxygen by weight, and, in some further embodiments, the glass core 1510 may further include at least 5% aluminum by weight. In some embodiments, the glass core 1510 may include any of the materials described above and may further include one or more additives such as Al₂O₃, B₂O₃, MgO, CaO, SrO, BaO, SnO₂, Na₂O, K₂O, SrO, P₂O₃, ZrO₂, Li₂O, Ti, and Zn. In some embodiments, the glass core 1510 may be a layer of glass that does not include an organic adhesive or an organic material. The glass core 1510 may be distinguished from, for example, the "prepreg" or "FR4" core of a PCB substrate which typically includes glass fibers embedded in a resinous organic material such as an epoxy. In such traditional cores/substrates including glass fibers and epoxy, the diameter of the glass fibers is generally in the range of 5 micron to 200 micron. In contrast, the glass core 1510 may be a layer of glass that is about 10 millimeters on a side to about 250 millimeters on a side (e.g., 10 millimeters x 10 millimeters to 250 millimeters x 250 millimeters).

In some embodiments, a cross-section of the glass core 1510 in an x-z plane, a y-z plane, and/or an x-y plane of an example coordinate system shown in FIG. 15A, may be substantially rectangular (axes shown in subsequent drawings refer to the axes of the coordinate system shown in FIG. 15A), although in some further embodiments the glass core 1510 may have rounded or beveled edges/sides/sidewalls. In some embodiments, in the top-down view of the glass core 1510 (e.g., the x-y plane of the coordinate system shown in FIG. 15A), the glass core 1510 may have a first length in a range of 10 millimeters to 250 millimeters, and a second length in a range of 10 millimeters to 250 millimeters, the first length perpendicular to the second length. A thickness of the glass core 1510 (e.g., a dimension measured along the z-axis of the coordinate system of FIG. 15A) may be in a range of about 50 micron to 1.4 millimeters. In some embodiments, the glass core 1510 may be a glass core substrate, where the glass core substrate has a thickness in a range of about 50 microns to 1.4 millimeters. In some embodiments, the glass core 1510 may be a layer of glass comprising a rectangular prism volume, possibly with rounded or beveled edges/sides/sidewalls. In some such embodiments, the rectangular prism volume may have a first side and a second side perpendicular to the first side, the first side having a length in a range of 10 millimeters to 250 millimeters and the second side having a length in a range of 10 millimeters to 250 millimeters. In some embodiments, the glass core 1510 may be a rectangular prism volume with sections (e.g., vias) removed and filled with other materials (e.g., metal) e.g., the TGVs 1515. In some embodiments, the glass core 1510 may be a layer of glass having a thickness in a range of 50 microns to 1.4 millimeters, a first length in a range of 10 millimeters to 250 millimeters, and a second length in a range of 10 millimeters to 250 millimeters, the first length perpendicular to the second length. In some implementations, together, the dielectric material 1512 and the glass core 1510 may be referred to as a "multi-layer glass substrate." In some such embodiments, the glass core 1510 may be a glass layer having a thickness in a range of about 25 microns to 50 microns.

In the example in FIG. 15A, the glass core 1510 includes through glass vias (TGVs) 1515. In the illustrated example, some of the TGVs may be or include conductive vias that include a conductive material to form conductive interconnects. For example, the TGVs 1515 are conductive vias that may include any appropriate conductive material, e.g., a metal such as copper, silver, nickel, gold, aluminum, or other metals or alloys. The TGVs 1515 may be vias extending between a first side and a second side of the glass core 1510 (e.g., between the bottom face and the top face of the glass core 1510). The openings for the TGVs 1515 may be formed using any suitable process, including, for example, a direct laser drilling or laser-induced etching process (which may also be referred to as laser patterning or selective laser activation). In some embodiments, the TGVs 1515 disclosed herein may have a pitch between 50 microns and 500 microns, e.g., as measured from a center of one TGV 1515 to a center of an adjacent TGV 1515. The TGVs 1515 may have any suitable size and shape. In some embodiments, the TGVs 1515 may have a round (e.g., circular or oval), rectangular, or other shaped cross-section. In some embodiments, at least some of the TGVs 1515 may have an hourglass shape (e.g., the TGVs 1515 may taper from both sides so that the TGVs have a narrower width between two larger widths). In some embodiments, at least some of the TGVs 1515 may taper down from one face of the glass core 1510 to another, e.g., from the top face of the glass core 1510 to the bottom face of the glass core 1510.

FIG. 15B illustrates another example substrate 1501B with a glass core 1510. The substrate 1501B resembles the substrate 1501A; however, the substrate 1501B includes a cavity 1570 in the substrate 1501B in which a die 1506 may be embedded and attached. The die may be an example of the dies 206-1, 206-2, 207, 806-1, 806-2, 807-1, 807-2, and 906, discussed above. In the example illustrated in FIG. 15B, the die 1506 may be attached to the substrate 1501B at the bottom of the cavity 1570 with an adhesive material 1580, such as a die attach film. The cavity may be filled with another insulator material 1582 to secure the die 1506 in the cavity 1570. The die 1506 may be a TSV-less die without conductive contacts at the bottom of the die 1506. In one example, the die 1506 lacks conductive contacts that are in direct contact with contacts of the substrate 1501B. Instead, as described above, the die 1506 may couple with an interposer that may be above and coupled with the substrate 1501B. In one such example, the die 1506 is surrounded by insulator materials on the sides 1581 and the face of the die 1506 that is facing the substrate 1501B (e.g., the face of the die 1506 attached to the substrate with the adhesive material 1580).

FIG. 15C illustrates a coreless substrate 1501C that lacks a glass core. The substrate 1501C includes a dielectric material 1512 and a conductive material 1508 arranged in the one or more layers of the dielectric material 1512 to provide conductive pathways (e.g., conductive traces 1508A and conductive vias 1508B) through the substrate 1501C, as well as to provide conductive pads and contacts. Although not shown, a coreless substrate such as the substrate 1501C may also include a cavity to accommodate a TSV-less die, such as shown in FIG. 15B.

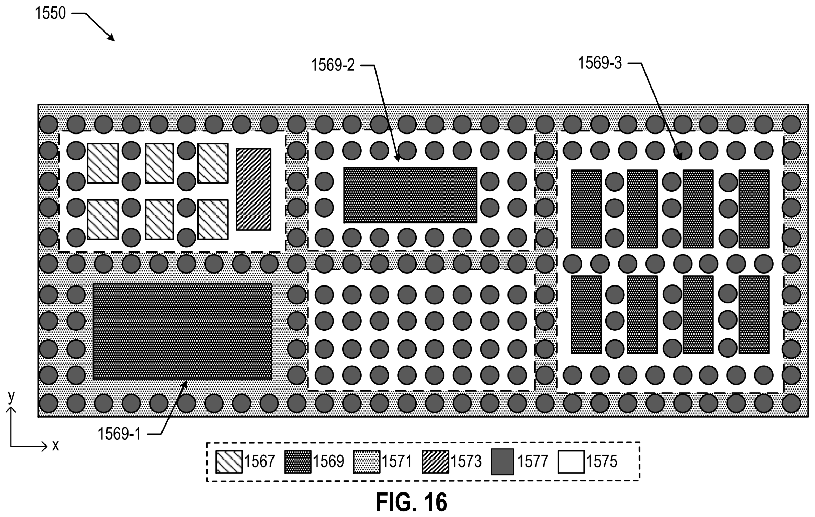

FIG. 16 illustrates a plan view of an example of a system 1550 that may be implemented as, or include, a microelectronic assembly with disaggregated components, in accordance with embodiments of the present disclosure. In the example illustrated in FIG. 16, the system 1550 includes a plurality of dies 1575, which may be attached to an interposer 1571 (e.g., a top or front side of an interposer). The dies 1575 may be examples of the dies 204-1, 204-2, and 204-3, discussed above. The interposer 1571 may be, e.g., the interposer 202 of FIG. 1A. In one such example, the interposer is an organic interposer. The system 1550 includes components/dies 1567, 1567, and 1573 between one or more layers of the interposer 1571 and a substrate (substrate not shown in FIG. 16) below the interposer. The dies 1567, 1567, and 1573 may be attached to the back side of an interposer, embedded in the interposer, and/or embedded in a substrate, in accordance with examples described herein. The dies 1567, 1567, and 1573 may be coplanar with conductive bumps 1577, which may include one or more of solder balls/bumps, metal pillars, and solder caps. In the example illustrated in FIG. 16, the dies 1567 may represent capacitor dies, the die 1569 may represent memory dies, and the die 1573 may represent a voltage regulator die. In one such example, the memory die 1569-1 may provide nonvolatile storage to the system 1550 and/or to a specific one of the dies 1575; the memory die 1569-2 may provide cache (e.g., expanded system cache for the die 1575 aligned with the memory die 1569-2); and the memory dies 1569-3 may provide cache to the die 1575 aligned with the dies 1569-3 (e.g., modular graphics cache). However, other types of dies may be attached to the back side of an interposer, embedded in the interposer, and/or embedded in a substrate, instead of, or in addition to, the example dies 1567, 1567, and 1573 shown in FIG. 16.

Thus, microelectronic assemblies with disaggregated components as described herein may enable lower-cost and high-flexibility disaggregated assemblies. In one example, an assembly includes an interposer over a substrate and conductive interconnects (e.g., one or more of conductive pillars, solder caps, and solder balls) between and coupled with the substrate and the interposer. One or more dies (such as processor dies, etc.), may be coupled with a top side of the interposer. A further die may be coupled with the package side (e.g., bottom side) of the interposer. The further die may be, for example, in the bump field between the interposer and the substrate (e.g., coplanar with conductive pillars or solder balls). In some examples, the further die may be embedded in the substrate. In some examples, the further die may be TSV-less, and therefore lack conductive interconnects in direct contact with conductive contacts of the substrate. In other examples, the further die may be embedded within RDLs of the interposer. In one such example, the further die may be coplanar with conductive pillars between and coupled with an RDL above and an RDL below the further die. In some examples, the further die may provide capacitors, routing, and/or memory to one or more of the dies on the top of the interposer.

Microelectronic assembly features described above may be combined. For example, the underfill material 240 shown in FIG. 2 may be present between the interposer 202 and the dies 206-1, 206-2, and 207 of FIGS. 3-7. In another example, although FIGS. 1A and 2-7 illustrate examples where the dies 206-1, 206-2, and 207 are coupled with the interposer 202 with solder balls, in other examples, the dies 206-1, 206-2, and 207 may be coupled with the interposer 202 with conductive pillars, instead of or in addition to solder balls. Similarly, the dies 806 and 807 of FIG. 8B may be coupled with the RDLs 821 with conductive pillars instead of or in addition to solder balls, and the die 906 of FIGS. 9-13 may be coupled with the interposer 902 with solder balls instead of, or in addition to, the conductive pillars. Although specific examples show dies as either attached to a back side of an interposer or embedded in an interposer or a substrate, a microelectronic assembly may include one or more dies attached to a back side of an interposer, embedded in an interposer, and/or embedded in a substrate. Note that although particular examples of pitches and widths of conductive bumps are provided, other pitches and widths are possible. Furthermore, the bump distribution in a given interface may not be uniform (e.g., some bumps may have larger widths than others in the same bump field).

IC assemblies including disaggregated components in accordance with examples described herein may include or be included in any suitable electronic component or electronic device. FIGS. 16-19 illustrate various examples of apparatuses that may include or be included in an IC assembly including disaggregated components as disclosed herein.

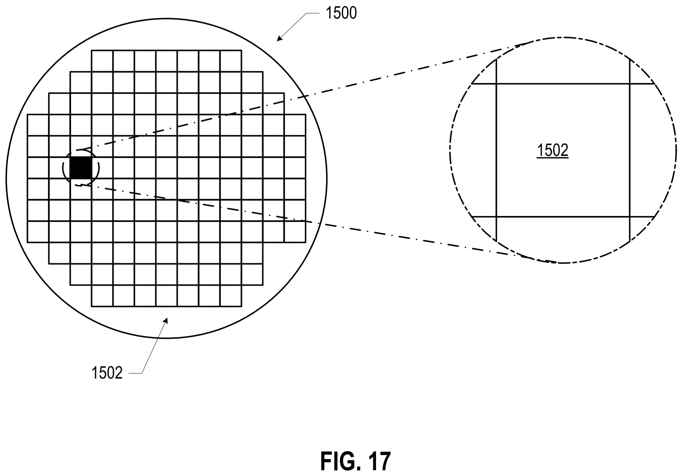

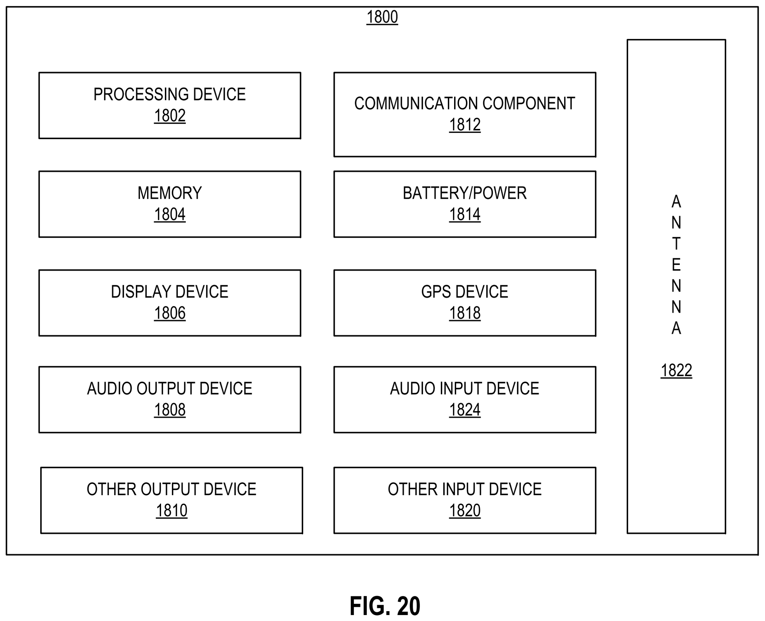

FIG. 17 is a top view of a wafer 1500 and dies 1502 that may include or be included in one or more IC structures or assemblies in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. In some embodiments, the wafer 1500 or the die 1502 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 20) or other logic that is configured to store information in the memory devices or execute instructions stored in the memory array.

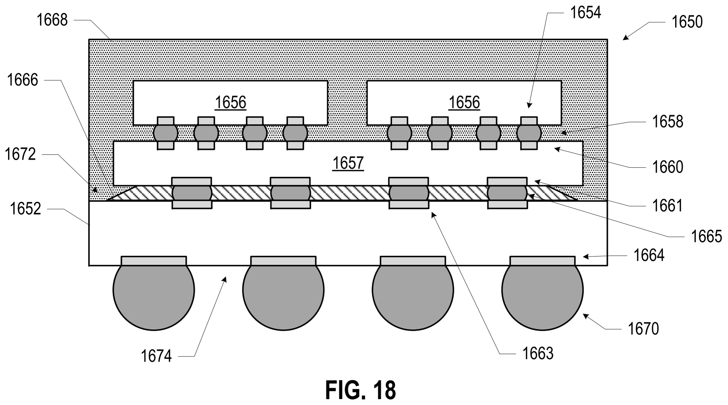

FIG. 18 is a side, cross-sectional view of an example IC package 1650 that may include or be included in a microelectronic assembly in accordance with any of the embodiments disclosed herein. In some embodiments, the IC package 1650 may be a system-in-package (SiP).

The package substrate 1652 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 1672 and the face 1674, or between different locations on the face 1672, and/or between different locations on the face 1674.

The package substrate 1652 may include conductive contacts 1663 that are coupled to conductive pathways (not shown) through the package substrate 1652, allowing circuitry within the dies 1656 and/or the interposer 1657 to electrically couple to various ones of the conductive contacts 1664 (or to devices included in the package substrate 1652, not shown).

The IC package 1650 may include an interposer 1657 coupled to the package substrate 1652 via conductive contacts 1661 of the interposer 1657, first-level interconnects 1665, and the conductive contacts 1663 of the package substrate 1652. The first-level interconnects 1665 illustrated in FIG. 18 are solder bumps, but any suitable first-level interconnects 1665 may be used. In some embodiments, no interposer 1657 may be included in the IC package 1650; instead, the dies 1656 may be coupled directly to the conductive contacts 1663 at the face 1672 by first-level interconnects 1665. More generally, one or more dies 1656 may be coupled to the package substrate 1652 via any suitable structure (e.g., a silicon bridge, an organic bridge, one or more waveguides, one or more interposers, wirebonds, etc.).

The IC package 1650 may include one or more dies 1656 coupled to the interposer 1657 via conductive contacts 1654 of the dies 1656, first-level interconnects 1658, and conductive contacts 1660 of the interposer 1657. The conductive contacts 1660 may be coupled to conductive pathways (not shown) through the interposer 1657, allowing circuitry within the dies 1656 to electrically couple to various ones of the conductive contacts 1661 (or to other devices included in the interposer 1657, not shown). The first-level interconnects 1658 illustrated in FIG. 18 are solder bumps, but any suitable first-level interconnects 1658 may be used. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

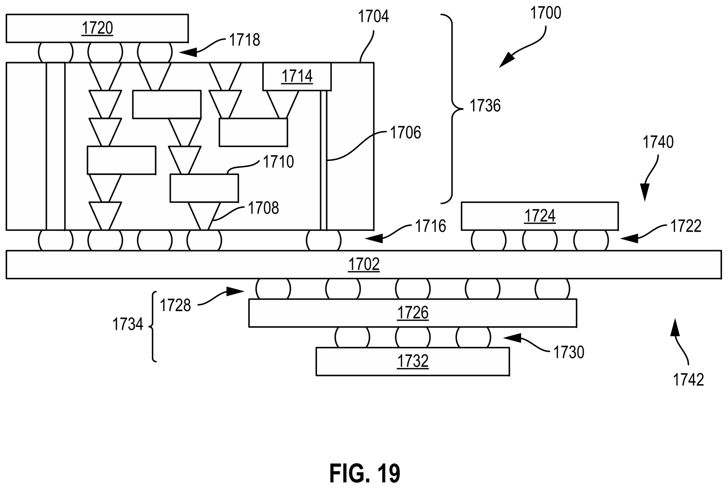

In some embodiments, an underfill material 1666 may be disposed between the package substrate 1652 and the interposer 1657 around the first-level interconnects 1665, and a mold compound 1668 may be disposed around the dies 1656 and the interposer 1657 and in contact with the package substrate 1652. In some embodiments, the underfill material 1666 may be the same as the mold compound 1668. Example materials that may be used for the underfill material 1666 and the mold compound 1668 are epoxy mold materials, as suitable. Second-level interconnects 1670 may be coupled to the conductive contacts 1664. The second-level interconnects 1670 illustrated in FIG. 18 are solder balls (e.g., for a BGA arrangement), but any suitable second-level interconnects 1670 may be used (e.g., pins in a pin grid array arrangement or lands in a land grid array arrangement). The second-level interconnects 1670 may be used to couple the IC package 1650 to another component, such as a circuit board (e.g., a motherboard), an interposer, or another IC package, as known in the art and as discussed below with reference to FIG. 19.

The dies 1656 may take the form of any of the embodiments of the die 1502 discussed herein. In embodiments in which the IC package 1650 includes multiple dies 1656, the IC package 1650 may be referred to as a multi-chip package (MCP). The dies 1656 may include circuitry to perform any desired functionality. For example, or more of the dies 1656 may be logic dies (e.g., silicon-based dies), and one or more of the dies 1656 may be memory dies (e.g., high bandwidth memory).

Although the IC package 1650 illustrated in FIG. 18 is a flip chip package, other package architectures may be used. For example, the IC package 1650 may be a BGA package, such as an embedded wafer-level ball grid array (eWLB) package. In another example, the IC package 1650 may be a wafer-level chip scale package (WLCSP) or a panel fanout (FO) package. Although two dies 1656 are illustrated in the IC package 1650 of FIG. 18, an IC package 1650 may include any desired number of dies 1656. An IC package 1650 may include additional passive components, such as surface-mount resistors, capacitors, and inductors disposed on the first face 1672 or the second face 1674 of the package substrate 1652, or on either face of the interposer 1657. More generally, an IC package 1650 may include any other active or passive components known in the art.

FIG. 19 is a side, cross-sectional view of an IC device assembly 1700 that may include one or more IC packages or other electronic components (e.g., a die) including an organic interposer with a fanout routing die in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the IC package 1650 discussed above with reference to FIG. 18 (e.g., may include one or more IC structures in accordance with embodiments described herein).

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 19 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 19), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 19, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 17), an IC device, or any other suitable component. Generally, the package interposer 1704 may spread a connection to a wider pitch or reroute a connection to a different connection. For example, the package interposer 1704 may couple the IC package 1720 (e.g., a die) to a set of BGA conductive contacts of the coupling components 1716 for coupling to the circuit board 1702. In the embodiment illustrated in FIG. 19, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a PCB, including multiple metal layers separated from one another by layers of dielectric material and interconnected by electrically conductive vias. In some embodiments, the package interposer 1704 may be formed of an epoxy resin, a fiberglass-reinforced epoxy resin, an epoxy resin with inorganic filters, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal lines 1710 and vias 1708, including but not limited to TSVs 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as RF devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 19 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 20 is a block diagram of an example electrical device 1800 that may include or be included in a microelectronic assembly with an organic interposer with a fanout routing die in accordance with any of the embodiments disclosed herein. For example, any suitable ones of the components of the electrical device 1800 may include one or more of the IC device assemblies 1700, IC packages 1650, or dies 1502 disclosed herein. A number of components are illustrated in FIG. 20 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 20, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1800 may include a memory 1804, which may itself include one or more memory devices such as volatile memory (e.g., dynamic random access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded DRAM (eDRAM) or spin transfer torque magnetic random access memory (STT-MRAM).

In some embodiments, the electrical device 1800 may include a communication chip 1812 (e.g., one or more communication chips). For example, the communication chip 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include another output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include another input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a handheld or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server device or other networked computing component, a printer, a scanner, a monitor, a set-top box, an entertainment control unit, a vehicle control unit, a digital camera, a digital video recorder, or a wearable electrical device. In some embodiments, the electrical device 1800 may be any other electronic device that processes data.

The following paragraphs provide various examples of the embodiments disclosed herein.

Example 1 provides a microelectronic assembly, including an interposer including two or more interconnect layers, where the interposer has a first face and a second face opposite the first face, where: the first face (e.g., bottom side/back side of the interposer) includes first conductive contacts (e.g., with a first pitch) and second conductive contacts (e.g., with a second pitch, where wider contacts for coupling with the larger bumps/substrate and smaller contacts for coupling with smaller bumps/die), the second face (e.g., top side/front side of the interposer) includes third conductive contacts (e.g., with a third pitch, where the third contacts are for coupling with chiplets, processor die, etc. coupled with the top of the interposer); conductive bumps coupled with the first conductive contacts; and a die (e.g., bridge die, die with capacitor, etc.) coupled with the second conductive contacts in a layer with the conductive bumps (e.g., in the bump field).

Example 2 provides the microelectronic assembly of example 1, where: the conductive bumps include a first conductive bump and a second conductive bump coplanar with the first conductive bump, and the die is between the first conductive bump and the second conductive bump.

Example 3 provides the microelectronic assembly of example 2, where: the die includes four sides, including a first side, a second side opposite the first side, a third side, and a fourth side opposite the third side, the first conductive bump is adjacent to the first side and the second conductive bump is adjacent to the second side, the conductive bumps further include a third conductive bump and a fourth conductive bump, and the third conductive bump is adjacent to the third side and the fourth conductive bump is adjacent to the fourth side.

Example 4 provides the microelectronic assembly of any one of examples 1-3, further including second conductive bumps (e.g., bumps between the die and bottom side of the interposer) between and coupled with the die and the second conductive contacts; and a void between the first face and the die in a plane with the second conductive bumps, where the plane is substantially parallel with the interposer (e.g., there may be no underfill between the die and the bottom side of the interposer).

Example 5 provides the microelectronic assembly of any one of examples 1-3, further including second conductive bumps between and coupled with the die and the second conductive contacts; and a dielectric material (e.g., an underfill material) between the first face and the die in a plane with the second conductive bumps, where the plane is substantially parallel with the interposer.

Example 6 provides the microelectronic assembly of example 5, where: the dielectric material is absent between adjacent bumps of the conductive bumps (e.g., the underfill material may be limited to the region between the die and the bottom side of the interposer).

Example 7 provides the microelectronic assembly of any one of examples 1-6, further including a substrate including third conductive contacts coupled with the conductive bumps; and an airgap between the die and the substrate.

Example 8 provides the microelectronic assembly of any one of examples 1-6, further including a substrate including third conductive contacts coupled with the conductive bumps; and a continuous portion of a dielectric material between the die and the substrate, where conductive interconnects are absent from the continuous portion of the dielectric material (e.g., there may be underfill material between the die and the substrate).

Example 9 provides the microelectronic assembly of any one of examples 1-8, where: the die is a passive die including a conductive interconnect coupled with a first of the second conductive contacts and a second of the second conductive contacts.

Example 10 provides the microelectronic assembly of any one of examples 1-8, where: the die includes one or more transistors.

Example 11 provides the microelectronic assembly of any one of examples 1-8, where: the die includes a memory array.

Example 12 provides the microelectronic assembly of any one of examples 1-8, further including a further die (e.g., processor die) coupled with the third conductive contacts, where: the die is under and substantially aligned with the further die, and the die includes a capacitor.

Example 13 provides the microelectronic assembly of any one of examples 1-12, where: the die includes a first die face and a second die face opposite the first die face, and the die lacks a via that extends from the first die face to the second die face.

Example 14 provides the microelectronic assembly of any one of examples 1-12, where the die is a first die, and where the microelectronic assembly further includes a second die coplanar with the first die, where: one or more of the conductive bumps are between the first die and the second die in the layer.

Example 15 provides the microelectronic assembly of any one of examples 1-14, where: the die is in a same plane with the conductive bumps, where the plane is substantially parallel with the interposer.

Example 16 provides the microelectronic assembly of any one of examples 1-14, further including a dielectric material (e.g., molding material) at least partially around the die; and a conductive pillar through the dielectric material, where the conductive pillar is between and coupled with one of the conductive bumps and a conductive interconnect of the interposer, where: the die is in a same plane as the conductive pillar, and the plane is substantially parallel with the interposer.

Example 17 provides the microelectronic assembly of example 16, where the dielectric material is a first dielectric material, and where the microelectronic assembly further includes a second dielectric material at least partially around the conductive bumps (e.g., there may be an underfill material around the bumps and between the substrate and the molding material).

Example 18 provides the microelectronic assembly of example 1, where: the die is coupled with the second conductive contacts with first conductive pillars, the conductive bumps include second conductive pillars (e.g., where the first conductive contacts are recessed in the dielectric material of an RDL of the interposer), a side of the die facing away from the interposer is at a distance from the first face, and a height of one of the second conductive pillars is greater than the distance.

Example 19 provides the microelectronic assembly of example 18, further including a substrate below the interposer and the die; fourth conductive contacts on the substrate, where the conductive pillars are between and coupled with the first conductive contacts and the fourth conductive contacts; and solder caps between the conductive pillars and the fourth conductive contacts.

Example 20 provides the microelectronic assembly of example 19, further including an underfill material at least partially around the conductive pillars, where: a portion of the underfill material between the die and the substrate is in a plane with the conductive pillars.

Example 21 provides the microelectronic assembly of example 20, where the underfill material is a first underfill material, and where the microelectronic assembly further includes a second underfill material between the die and the interposer.

Example 22 provides the microelectronic assembly of example 1, where: the die is coupled with the second conductive contacts with first conductive pillars, the conductive bumps include second conductive pillars (e.g., where the first conductive contacts are recessed in the dielectric material of an RDL of the interposer), a side of the die facing away from the interposer is at a distance from the first face, and a height of one of the second conductive pillars is smaller than the distance.

Example 23 provides the microelectronic assembly of example 22, further including a substrate below the interposer and the die; fourth conductive contacts on the substrate; and solder bumps between and coupled with the fourth conductive contacts and the second conductive pillars.

Example 24 provides the microelectronic assembly of any one of examples 22-23, where: the die is in a plane with the solder bumps.

Example 25 provides the microelectronic assembly of any one of examples 22-24, further including a solder cap between and coupled with a pillar of the conductive pillars and a solder bump of the solder bumps.

Example 26 provides the microelectronic assembly of example 25, further including an interface between the solder cap and the solder bump.

Example 27 provides the microelectronic assembly of any one of examples 19-26, further including a solder mask layer over the substrate, where: the fourth conductive contacts are in openings in the solder mask layer.

Example 28 provides the microelectronic assembly of example 27, further including an underfill material between the die and the substrate, where a portion of the underfill material is between and in contact with the solder mask layer and the die.

Example 29 provides the microelectronic assembly of example 27, further including an underfill material between the die and the substrate, where a portion of the underfill material is coplanar with the solder mask layer and in contact with the substrate and the die.

Example 30 provides the microelectronic assembly of example 29, where: a face of the die is coplanar with the solder mask layer.

Example 31 provides the microelectronic assembly of any one of examples 27-30, where: the solder mask has a thickness in a range of 35 to 50 microns.

Example 32 provides the microelectronic assembly of any one of examples 27-30, further including an underfill material between the interposer and the solder mask; and a layer of an insulator material (e.g., dry resist film) between the solder mask and the underfill material.

Example 33 provides the microelectronic assembly of example 32, where: the die is coplanar with one or both of the layer of the insulator material and the solder mask.

Example 34 provides the microelectronic assembly of any one of examples 32-33, where: the layer of the insulator material (e.g., dry resist film) has a first thickness in a range of 15 to 30 microns, and the solder mask has a second thickness in a range of 15 to 30 microns.

Example 35 provides a microelectronic assembly, including an interposer including a first layer of a dielectric material (e.g., first RDL) and a second layer of the dielectric material (e.g., second RDL) over the first layer; a first die between the first layer and the second layer; a second die between the first layer and the second layer and coplanar with the first die; an insulator material (e.g., molding material) at least partially around and between the first die and the second die; and a conductive pillar through the dielectric material between (e.g., extending between) the first layer and the second layer, where the conductive pillar is between and coplanar with the first die and the second die.

Example 36 provides the microelectronic assembly of example 35, further including conductive interconnects (e.g., conductive bumps, pillars, etc.) between the first die and the second layer of the interposer, where the insulator material at least partially surrounds the conductive interconnects.

Example 37 provides the microelectronic assembly of any one of examples 35-36, where: conductive interconnectivity between the first die and the interposer is limited to a region between the first die and the second layer of the interposer (e.g., there may be no electrical/signal interconnects between the bottom of the die and the bottom layer of the interposer).

Example 38 provides the microelectronic assembly of any one of examples 35-37, where: a region between the first die and the first layer of the interposer includes a continuous portion of the insulator material (e.g., molding material is present between the die and the bottom layer of the interposer).

Example 39 provides the microelectronic assembly of any one of examples 35-38, where the conductive pillar is a first conductive pillar, and where the microelectronic assembly further includes a second conductive pillar through the insulator material between the first layer and the second layer, where: the first die is between the first conductive pillar and the second conductive pillar.

Example 40 provides the microelectronic assembly of example 39, where: the first die includes four sides, including a first side, a second side opposite the first side, a third side, and a fourth side opposite the third side, the first conductive pillar is adjacent to the first side and the second conductive pillar is adjacent to the second side, a third conductive pillar is adjacent to the third side, and a fourth conductive pillar is adjacent to the fourth side.

Example 41 provides the microelectronic assembly of any one of examples 35-40, further including an adhesive film (e.g., die attach film) between the first layer of the interposer and the first die. For example, the microelectronic assembly of any one of examples 35-40 may include an adhesive film (e.g., die attach film) between the first layer of the interposer and the first die in a plane with the conductive pillar, wherein the plane is substantially parallel with the interposer.

Example 42 provides the microelectronic assembly of any one of examples 35-41, where: the first die includes a first interconnect die, and the second die includes a second interconnect die.

Example 43 provides the microelectronic assembly of any one of examples 35-41, where: the first die includes a first capacitor, and the second die includes a second capacitor.

Example 44 provides a microelectronic assembly, including a substrate; an interposer over the substrate; conductive interconnects (e.g., bumps, pillars, etc.) between and coupled with the substrate and the interposer; one or more first dies over and bonded with a first side (e.g., front side) of the interposer; and a second die below and bonded with a second side of the interposer opposite the first side, where: the second die is between the substrate and the interposer, and conductive contacts on the second die are limited to a side of the second die facing the second side of the interposer.

Example 45 provides the microelectronic assembly of example 44, where: the conductive interconnects include one or both of: conductive bumps and conductive pillars, and the second die is coplanar with the conductive interconnects.

Example 46 provides the microelectronic assembly of any one of examples 44-45, further including a third die below and bonded with the second side of the interposer, where one or more of the conductive interconnects are between the second die and the third die.

Example 47 provides the microelectronic assembly of any one of examples 44-46, where: the conductive interconnects are disposed around two or more edges of the second die.

Example 48 provides the microelectronic assembly of any one of examples 44-47, where the conductive interconnects are first conductive interconnects, and where the microelectronic assembly further includes second conductive interconnects between and coupled with the second die and the second side of the interposer.

Example 49 provides the microelectronic assembly of example 48, further including an airgap between the second die and the second side of the interposer in a plane with the second conductive interconnects.

Example 50 provides the microelectronic assembly of example 48, further including an underfill material between the second die and the second side of the interposer in a plane with the second conductive interconnects.

Example 51 provides the microelectronic assembly of any one of examples 44-50, further including; an airgap between the second die and the substrate.

Example 52 provides the microelectronic assembly of any one of examples 44-50, further including an underfill material between the second die and the substrate.

Example 53 provides the microelectronic assembly of any one of examples 44-52, further including a molding material at least partially around the second die, where the conductive interconnects include conductive pillars through the molding material.

Example 54 provides the microelectronic assembly of example 53, further including conductive bumps substantially aligned with and between the conductive pillars and the substrate.

Example 55 provides the microelectronic assembly of example 54, further including an underfill material at least partially around the conductive bumps and between the substrate and the molding material.

Example 56 provides the microelectronic assembly of example 44, where: the substrate includes a recessed region, and the second die is in the recessed region.

Example 57 provides the microelectronic assembly of example 56, further including an adhesive material between the second die and the substrate. For example, the microelectronic assembly of example 56 may include an adhesive material between the second die and the substrate, wherein further conductive interconnects are absent through the adhesive material.

Example 58 provides the microelectronic assembly of any one of examples 56-57, where: the substrate has a first substrate side facing the interposer, and the side of the second die facing the second side of the interposer is in substantially a same plane as the first substrate side (e.g., the top of the die may be about level with the top of the substrate).

Example 59 provides the microelectronic assembly of any one of examples 56-58, further including an underfill material at least partially around the conductive interconnects and between the second side of the interposer and the substrate.

Example 60 provides the microelectronic assembly of example 59, where: the recessed region includes a portion of the underfill material between the second die and an insulator material of the substrate (e.g., there is an underfill material around the die in the recessed region).

Example 61 provides the microelectronic assembly of any one of examples 59-60, further including a solder mask material on the first substrate side, where the conductive contacts on the second die are coplanar with the solder mask material.

Example 62 provides the microelectronic assembly according to any one of examples 1-61, where the microelectronic assembly includes or is a part of a central processing unit.

Example 63 provides the microelectronic assembly according to any one of examples 1-62, where the microelectronic assembly includes or is a part of a memory device.

Example 64 provides the microelectronic assembly according to any one of examples 1-63, where the microelectronic assembly includes or is a part of a logic circuit.

Example 65 provides the microelectronic assembly according to any one of examples 1-64, where the microelectronic assembly includes or is a part of input/output circuitry.

Example 66 provides the microelectronic assembly according to any one of examples 1-65, where the microelectronic assembly includes or is a part of a field programmable gate array transceiver.

Example 67 provides the microelectronic assembly according to any one of examples 1-66, where the microelectronic assembly includes or is a part of a field programmable gate array logic.

Example 68 provides the microelectronic assembly according to any one of examples 1-67, where the microelectronic assembly includes or is a part of a power delivery circuitry.

Example 69 provides an IC package that includes a microelectronic assembly according to any one of examples 1-68.

Example 70 provides the IC package according to example 69, further including a further IC component coupled to the microelectronic assembly.

Example 71 provides the IC package according to example 70, where the further IC component includes a package substrate.

Example 72 provides the IC package according to example 70, where the further IC component includes an interposer.

Example 73 provides the IC package according to example 70, where the further IC component includes a further assembly or die.

Example 74 provides a computing device that includes a carrier substrate and an assembly coupled to the carrier substrate, where the assembly is an assembly according to any one of examples 1-68, or the assembly is included in the IC package according to any one of examples 69-73.

Example 75 provides the computing device according to example 74, where the computing device is a wearable or handheld computing device.

Example 76 provides the computing device according to examples 74 or 75, where the computing device further includes one or more communication chips.

Example 77 provides the computing device according to any one of examples 74-76, where the computing device further includes an antenna.

Example 78 provides the computing device according to any one of examples 74-77, where the carrier substrate is a motherboard.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. A microelectronic assembly, comprising:
an interposer comprising two or more interconnect layers, wherein the interposer has a first face and a second face opposite the first face, wherein:
the first face comprises first conductive contacts and second conductive contacts, and
the second face comprises third conductive contacts;
conductive bumps coupled with the first conductive contacts; and
a die coupled with the second conductive contacts in a layer with the conductive bumps.

2. The microelectronic assembly of claim 1, wherein:
the conductive bumps comprise a first conductive bump and a second conductive bump coplanar with the first conductive bump, and
the die is between the first conductive bump and the second conductive bump.

3. The microelectronic assembly of claim 2, wherein:
the die comprises four sides, including a first side, a second side opposite the first side, a third side, and a fourth side opposite the third side,
the first conductive bump is adjacent to the first side and the second conductive bump is adjacent to the second side,
the conductive bumps further comprise a third conductive bump and a fourth conductive bump, and
the third conductive bump is adjacent to the third side and the fourth conductive bump is adjacent to the fourth side.

4. The microelectronic assembly of any one of claims 1-3, wherein the conductive bumps are first conductive bumps, and wherein the microelectronic assembly further comprises:
second conductive bumps between and coupled with the die and the second conductive contacts; and
a void between the first face and the die in a plane with the second conductive bumps, wherein the plane is substantially parallel with the interposer.

5. The microelectronic assembly of any one of claims 1-3, wherein the conductive bumps are first conductive bumps, and wherein the microelectronic assembly further comprises:
second conductive bumps between and coupled with the die and the second conductive contacts; and
a dielectric material between the first face and the die in a plane with the second conductive bumps, wherein the plane is substantially parallel with the interposer.

6. The microelectronic assembly of any one of claims 1-5, further comprising:
a substrate comprising fourth conductive contacts coupled with the conductive bumps; and
an airgap between the die and the substrate.

7. The microelectronic assembly of any one of claims 1-5, further comprising:
a substrate comprising fourth conductive contacts coupled with the conductive bumps; and
a continuous portion of a dielectric material between the die and the substrate, wherein conductive interconnects are absent from the continuous portion of the dielectric material.

8. The microelectronic assembly of any one of claims 1-7, wherein:
the die comprises a first die face and a second die face opposite the first die face, and
the die lacks a via that extends from the first die face to the second die face.

9. The microelectronic assembly of any one of claims 1-7, wherein the die is a first die, and wherein the microelectronic assembly further comprises:
a second die coplanar with the first die, wherein:
one or more of the conductive bumps are between the first die and the second die in the layer.

10. The microelectronic assembly of any one of claims 1-9, wherein:
the die is in a same plane with the conductive bumps, wherein the plane is substantially parallel with the interposer.

11. The microelectronic assembly of any one of claims 1-9, further comprising:
a dielectric material at least partially around the die; and
a conductive pillar through the dielectric material, wherein the conductive pillar is between and coupled with one of the conductive bumps and a conductive interconnect of the interposer, wherein:
the die is in a same plane as the conductive pillar, and
the plane is substantially parallel with the interposer.

12. The microelectronic assembly of any one of claims 1-11, wherein:
the die is coupled with the second conductive contacts with first conductive pillars,
the conductive bumps comprise second conductive pillars,
a side of the die facing away from the interposer is at a distance from the first face, and
a height of one of the second conductive pillars is greater than the distance.

13. The microelectronic assembly of any one of claims 1-11, wherein:
the die is coupled with the second conductive contacts with first conductive pillars,
the conductive bumps comprise second conductive pillars,
a side of the die facing away from the interposer is at a distance from the first face, and
a height of one of the second conductive pillars is smaller than the distance.

14. The microelectronic assembly of claim 13, further comprising:
a substrate below the interposer and the die;
fourth conductive contacts on the substrate;
solder bumps between and coupled with the fourth conductive contacts and the second conductive pillars; and
a solder mask layer over the substrate, wherein the fourth conductive contacts are in openings in the solder mask layer.

15. The microelectronic assembly of any one of claims 1-14, wherein:
the two or more layers of the interposer comprise an organic dielectric material.
